# EUROPEAN PATENT APPLICATION

(11) **EP 2 009 499 A1**
(43) Date of publication of application: **31.12.2008**
(21) Application number: 07740750.0
(22) Date of filing: 30.03.2007
(51) Int. Cl.: G03F 7/11, C08F 20/24, H01L 21/027

(54) **MATERIAL OF THE RESIST-PROTECTING MEMBRANE FOR IMMERSION LITHOGRAPHY**

(30) Priority: 20.04.2006 JP 2006116735; 24.05.2006 JP 2006144121; 31.07.2006 JP 2006207392
(71) Applicant: Asahi Glass Company, Limited, Chiyoda-ku Tokyo 100-8405 (JP)
(72) Inventor: TAKEBE, Yoko, Tokyo 100-8405 (JP); WANG, Shu-zhong, Tokyo 100-8405 (JP); YOKOKOJI, Osamu, Tokyo 100-8405 (JP); SHIROTA, Naoko, Tokyo 100-8405 (JP); MATSUKAWA, Yasuhisa, Tokyo 100-8405 (JP); SHIRAKAWA, Daisuke, Tokyo 100-8405 (JP)
(74) Representative: Müller-Boré & Partner Patentanwälte
(86) International application number: PCT/JP2007/057314
(87) International publication number: WO 2007/122977

(57) **Abstract**

To provide a resist protective film material for immersion lithography.

An alkali soluble resist protective film material for immersion lithography, which comprises a polymer (F) containing repeating units (F^{U}) formed by polymerizing a polymerizable compound (f^{m}) having a fluorine-containing bridged cyclic structure. For example, repeating units (F^{U}) are repeating units formed by polymerizing a compound (f) selected from the group consisting of the following formulae (f1) to (f4) (R^{F} represents H, F, a C₁₋₃ alkyl group or a C₁₋₃ fluoroalkyl group, and X^{F} represents F, OH or CH₂OH.)

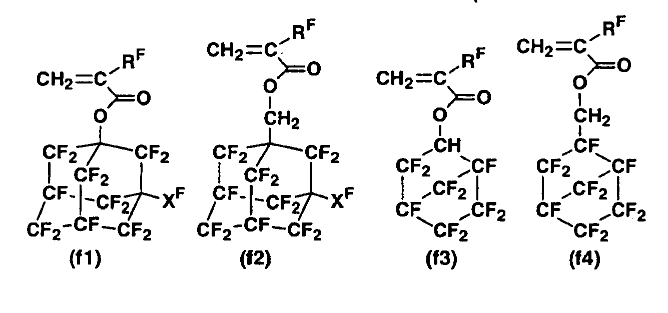

## Description

### TECHNICAL FIELD

The present invention relates to a material for a resist protective film for immersion lithography, a polymer for a resist protective film for immersion lithography, a composition for a resist protective film for immersion lithography, a composition for forming a resist protective film for immersion lithography and a method for forming a resist pattern.

### BACKGROUND ART

In the production of an integrated circuit for e.g. a semiconductor, a lithography method is employed, in which a pattern image of a mask obtained by irradiating the mask with light of an exposure light source, is projected onto a photosensitive resist on a substrate so as to transfer the pattern image on the photosensitive resist. Usually, the above pattern image is projected onto the desired position of a photosensitive resist through a projector lens which relatively moves over the photosensitive resist.

The resolution of a pattern image transferred onto a photosensitive resist improves as the wavelength of light of an exposure light source becomes short, and therefore short wavelength light (e.g. ArF eximer laser or F₂ laser) with a wavelength of at most 220 nm has been studied as an exposure light source. Further, a resist material to be used for a lithography method employing the short wavelength light, has been studied extensively. For example, as a photosensitive resist material to be used for a lithography method in which F₂ laser is employed as an exposure light source, a polymer of polyfluoroadamantyl (meth)acrylate (e.g. a copolymer of the following three compounds) is disclosed in Patent Document 1.

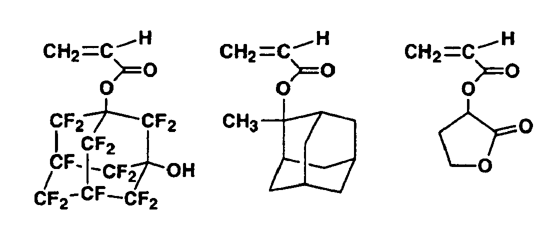

In recent years, an immersion lithography method has been studied, which contains an exposure step utilizing a phenomenon that the wavelength of light in a liquid medium is a reciprocal multiple of the refractive index of the liquid medium, namely, a step of projecting a pattern image of a mask onto a photosensitive resist through a projector lens while a liquid medium (liquid medium such as ultra-pure water) (hereinafter referred to as "immersion liquid") having a high refractive index fills a space between the bottom portion of the projector lens and the upper portion of the photosensitive resist (see e.g. Patent Document 2).

In such immersion lithography, the space between the projector lens and the photosensitive resist is filled with the immersion fluid, and therefore there is a concern that a component (such as a photo acid generator) in the photosensitive resist tends to be eluted in the immersion fluid, or the photosensitive resist tends to be swelled by the immersion fluid.

Accordingly, in such immersion lithography, it is attempted to suppress elution and swelling of the photosensitive resist by providing a resist protective film layer on the photosensitive resist.

As a material for such a resist protective film for immersion lithography, Patent Document 3 discloses a resist protective film composition containing a fluorinated surfactant and an alkali soluble polymer containing repeating units of a polymerizable compound (such as the following compound) having a polar group.

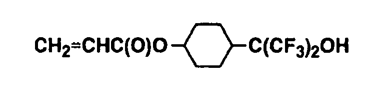

Further, Patent Document 4 discloses a resist protective film polymer made of a polymer containing the following repeating units formed by cyclopolymerization of CF₂=CFCF₂C(CF₃)(OR^{g})CH₂CH=CH₂ (b^{g} represents a hydrogen atom, or C₁₋₁₅ alkyloxy or alkyloxyalkyl group).

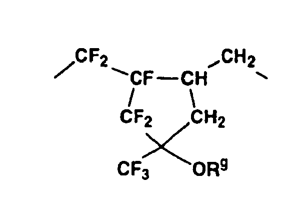

Patent Document 5 discloses a resist protective film polymer made of a copolymer of the following compound and an acyclic polyfluoroalkyl (meth)acrylate such as CF₂=CHC(O)OCH₂CF₂CF₂CF₂CHF₂. 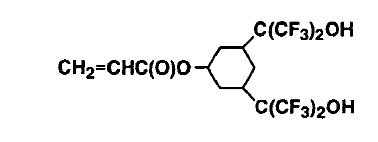 Patent Document 1: JP-A-2004-182796
Patent Document 2: WO99/049504
Patent Document 3: JP-A-2005-352384
Patent Document 4: JP-A-2005-264131
Patent Document 5: JP-A-2006-070244

### DISCLOSURE OF THE INVENTION

### PROBLEMS THAT THE INVENTION IS TO SOLVE

In an immersion lithography method employing a resist protective film layer, in order that the immersion fluid readily follows the projector lens which moves over a resist protective film, it is desirable to use a resist protective film material excellent in the dynamic liquid repellency. For example, in the case of an immersion lithography method employing water as the immersion fluid, it is desirable to use a resist protective film material excellent in the dynamic water repellency.

However, such a resist protective film material excellent in the dynamic water repellency has not been known. For example, a fluorinated surfactant disclosed in Patent Document 3 is merely a polymer made of a monomeric fluorine-containing compound and an acyclic fluoroalkyl (meth)acrylate, and the dynamic water repellency of the resist protective film composition in Patent Document 3 was low. Further, the dynamic water repellency of the resist protective film polymer in Patent Document 4 or 5 is still insufficient.

Accordingly, a resist protective film material for immersion lithography is required to have high dynamic water repellency and an ability of readily letting the immersion fluid follow the projector lens to be moved.

### MEANS TO SOLVE THE PROBLEMS

The present inventors have conducted extensive studies on obtaining a resist protective film material for immersion lithography excellent in characteristics (such as suppression of swelling of a photosensitive resist due to penetration of water or suppression of elution of a photosensitive resist component in a liquid medium) of a resist protective film for immersion lithography, and further excellent in the liquid repellency to the immersion fluid (such as water) and especially excellent in the dynamic liquid repellency. And as a result, they have found a resist protective film material for immersion lithography excellent in such characteristics.

Namely, the present invention provides the following:
(1) A material for an alkali soluble resist protective film for immersion lithography, which comprises a polymer (F) containing repeating units (F^{U}) formed by polymerization of a polymerizable compound (f^{m}) having a fluorine-containing bridged cyclic structure.
(2) The material for a resist protective film for immersion lithography according to (1), wherein the polymerizable compound (f^{m}) is a compound (f) selected from the group consisting of compounds represented by the following formulae (f1), (f2), (f3) and (f4): 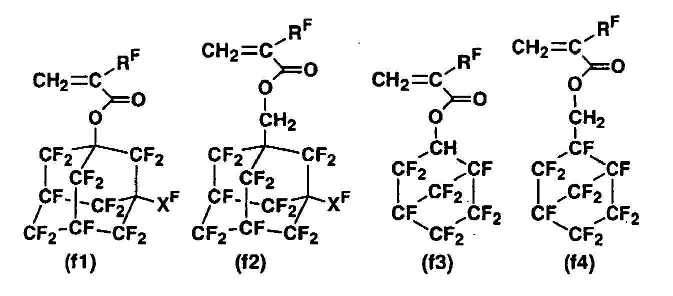 wherein the symbols have the following meanings:
   R^{F}: A hydrogen atom, a fluorine atom, a C₁₋₃ alkyl group or a C₁₋₃ fluoroalkyl group;
   X^{F}: A fluorine atom, a hydroxyl group or a hydroxymethyl group,
   wherein a fluorine atom in the compound (f) may be substituted by a C₁₋₆ perfluoroalkyl group or a C₁₋₆ perfluoroalkoxy group.
(3) A polymer for an alkali soluble resist protective film for immersion lithography, which is a polymer (FB) containing repeating units (F^{U}) formed by polymerization of a polymerizable compound (f^{m}) having a fluorine-containing bridged cyclic structure and repeating units (B^{U}) formed by polymerization of a polymerizable compound (b^{m}) having a hydroxyl group, a carboxyl group, a sulfonic acid group, a sulfonylamide group, an amino group or a phosphoric acid group.
(4) The polymer for a resist protective film for immersion lithography according to (3), wherein the polymerizable compound (f^{m}) is a compound (f) selected from the group consisting of compounds represented by the following formulae (f1), (f2), (f3) and (f4): 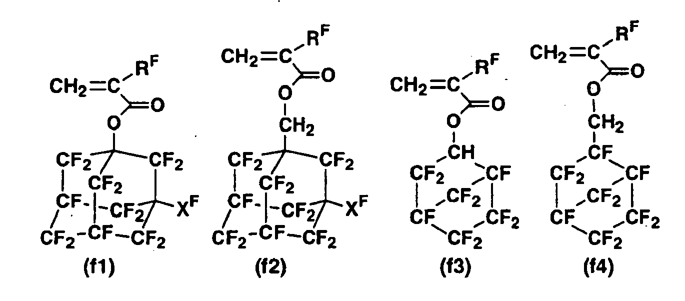 wherein the symbols have the following meanings:
   R^{F}: A hydrogen atom, a fluorine atom, a C₁₋₃ alkyl group or a C₁₋₃ fluoroalkyl group,
   X^{F}: A fluorine atom, a hydroxyl group or a hydroxymethyl group,
   wherein a fluorine atom in the compound (f) may be substituted by a C₁₋₆ perfluoroalkyl group or a C₁₋₆ perfluoroalkoxy group.
(5) The polymer for a resist protective film for immersion lithography according to (3) or (4), wherein the polymerizable compound (b^{m}) is a polymerizable compound having a group represented by the formula -C(CF₃) (OH)-, -C(CF₃)₂(OH) or -C(O)OH.
(6) The polymer for a resist protective film for immersion lithography according to any one of (3) to (5), wherein the polymerizable compound (b^{m}) is a compound (b) selected from the group consisting of compounds represented by the following formulae (b1), (b2), (b3) and (b4):

   CF₂=CF-Q^{B1}-CH=CH₂ (b1)

   CH₂=CR^{B2}-C(O)O-Q^{B2}(-C(CF₃)₂OH)_{b} (b2)

   CH₂=CH-Q^{B3}(-C(CF₃)₂OH)_{b} (b3)

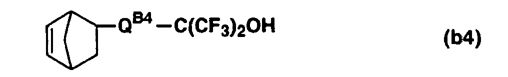

   wherein the symbols have the following meanings:
   Q^{B1}: A group represented by the formula
      -CF₂C(CF₃) (OH) (CH₂)ₘ-, a group represented by the formula -CH₂CH((CH₂)ₙC(CF₃)₂(OH))(CH₂)ₘ- or a group represented by the formula -CH₂CH(C(O)OH)(CH₂)ₘ-,
   m and n: Each independently 0, 1 or 2,
   R^{B2}: A hydrogen atom, a fluorine atom, a C₁₋₃ alkyl group or a C₁₋₃ fluoroalkyl group,
   Q^{B2} and Q^{B3}: Each independently a C₁₋₂₀ (b+1) valent hydrocarbon group,
   b: 1 or 2,
   Q^{B4}: a single bond or a C₁₋₁₀ bivalent hydrocarbon group,
   wherein a fluorine atom may be bonded to a carbon atom in Q^{B2}, Q^{B3} or Q^{B4}.
(7) The polymer for a resist protective film for immersion lithography according to any one of (3) to (6), wherein the polymer (FB) is a polymer containing from 1 to 70 mol% of repeating units (F^{U}) and at least 10 mol% of repeating units (B^{U}) based on the total amount of repeating units.
(8) The polymer for a resist protective film for immersion lithography according to any one of (3) to (7), wherein the polymer (FB) is a polymer containing from 3 to 15 mol% of repeating units (F^{U}) and from 85 to 97 mol% of repeating units (B^{U}) based on the total amount of repeating units.
(9) A composition for forming a resist protective film for immersion lithography, comprising the polymer for a resist protective film for immersion lithography as defined in any one of (3) to (8) and an organic solvent.
(10) A method for forming a resist pattern on a substrate, which is a method for forming a resist pattern by immersion lithography, which comprises sequentially carrying out a step of applying a photosensitive resist material on a substrate to form a photosensitive resist film on the substrate, a step of applying the composition for forming a resist protective film for immersion lithography as defined in (9) on the photosensitive resist film to form a resist protective film layer on the photosensitive resist film, a step of immersion lithography, and a step of development.
(11) An alkali soluble resist protective film composition for immersion lithography, which comprises a polymer (F) containing repeating units (F^{U}) formed by polymerization of a polymerizable compound (f^{m}) having a fluorine-containing bridged cyclic structure and a polymer (B) containing repeating units (B^{U}) formed by polymerization of a polymerizable compound (b^{m}) having a hydroxyl group, a carboxyl group, a sulfonic acid group, a sulfonylamide group, an amino group or a phosphoric acid group.
(12) The resist protective film composition for immersion lithography according to (11), wherein the polymerizable compound (f^{m}) is a compound (f) selected from the group consisting of compounds represented by the following formulae (f1), (f2), (f3) and (f4): 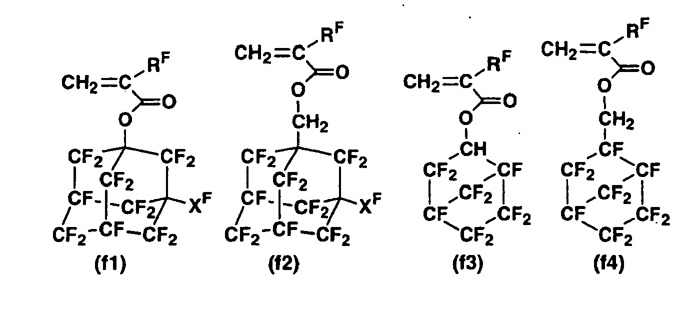 wherein the symbols have the following meanings:
   R^{F}: A hydrogen atom, a fluorine atom, a C₁₋₃ alkyl group or a C₁₋₃ fluoroalkyl group,
   X^{F}: A fluorine atom, a hydroxyl group or a hydroxymethyl group,
   wherein a fluorine atom in the compound (f) may be substituted by a C₁₋₆ perfluoroalkyl group or a C₁₋₆ perfluoroalkoxy group.
(13) The resist protective film composition for immersion lithography according to (11) or (12), wherein the polymerizable compound (b^{m}) is a polymerizable compound having a group represented by the formula -C(CF₃)(OH)-, -C(CF₃)₂(OH) or -C(O)OH.
(14) The resist protective film composition for immersion lithography according to any one of (11) to (13), wherein the polymerizable compound (b^{m}) is a compound (b) selected from the group consisting of compounds represented by the following formulae (b1), (b2), (b3) and (b4):

   CF₂=CF-Q^{B1}-CH=CH₂ (b1)

   CH₂=CR^{B2}-C(O)O-Q^{B2}(-C(CF₃)₂OH)_{b} (b2)

   CH₂=CH-Q^{B3}(-C(CF₃)₂OH)_{b} (b3)

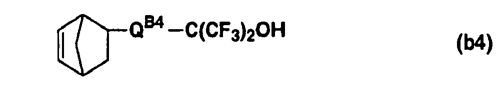

   wherein the symbols in the formulae have the following meanings:
   Q^{B1}: A group represented by the formula
      -CF₂C(CF₃)(OH)(CH₂)ₘ-, a group represented by the formula -CH₂CH((CH₂)ₙC(CF₃)₂(OH))(CH₂)ₘ- or a group represented by the formula -CH₂CH(C(O)OH)(CH₂)ₘ-,
   m and n: Each independently 0, 1 or 2,
   R^{B2}: A hydrogen atom, a fluorine atom, a C₁₋₃ alkyl group or a C₁₋₃ fluoroalkyl group,
   Q^{B2} and Q^{B3}: Each independently a C₁₋₂₀ (b+1) valent hydrocarbon group,
   b: 1 or 2,
   Q^{B4}: a single bond or a C₁₋₁₀ bivalent hydrocarbon group,
   wherein a carbon atom in Q^{B2}, Q^{B3} or Q^{B4} may be bonded to a fluorine atom.
(15) The resist protective film composition for immersion lithography according to any one of (11) to (14), wherein the polymer (F) is a polymer consisting solely of repeating units (F^{U}) formed by polymerizing a polymerizable compound (f^{m}) having a fluorine-containing bridged cyclic structure.
(16) The resist protective film composition for immersion lithography according to any one of (11) to (14), wherein the polymer (F) is a polymer containing repeating units (F^{U}) formed by polymerizing a polymerizable compound (f^{m}) having a fluorine-containing bridged cyclic structure and repeating units (B^{U}) formed by polymerizing a polymerizable compound (b^{m}) having a hydroxyl group, a carboxyl group, a sulfonic acid group, a sulfonylamide group, an amino group or a phosphoric acid group, and the polymer (F) is a polymer containing from 1 to 25 mol% of repeating units (F^{U}) and from 75 to 99 mol% of repeating units (B^{U}) based on the total amount of repeating units.
(17) The resist protective film composition for immersion lithography according to any one of (11) to (16), wherein the polymer (F) is contained in an amount of from 0.1 to 30 mass% based on the polymer (B).
(18) The resist protective film composition for immersion lithography according to (16), wherein the polymer (F) is contained in an amount of more than 30 mass% and at most 200 mass% based on the polymer (B).
(19) A composition for forming a resist protective film for immersion lithography, comprising the resist protective film composition for immersion lithography as defined in any one of (11) to (18) and an organic solvent.
(20) A method of forming a resist pattern on a substrate, which is a method of forming a resist pattern by immersion lithography, which comprises sequentially carrying out a step of applying a photosensitive resist material on a substrate to form a photosensitive resist film on a substrate, a step of applying the composition for forming a resist protective film for immersion lithography as defined in (19) on the photosensitive resist film to form a resist protective film layer on the photosensitive resist film, and a step of an immersion lithography, and a step of development.

### EFFECT OF THE INVENTION

According to the present invention, it is possible to provide a material for a resist protective film for immersion lithography, excellent in characteristics of a resist protective film and particularly excellent in the dynamic water repellency. By using the material for a resist protective film for immersion lithography, it is possible to stably conduct a high-speed immersion lithography method capable of transferring a pattern image of a mask with a high resolution.

### BEST MODE FOR CARRYING OUT THE INVENTION

In the present specification, a compound represented by the formula (f) is referred to as a compound (f), and a group represented by the formula -CF₂C(CF₃)(OH)(CH₂)ₘ-is referred to as -CF₂C(CF₃)(OH)(CH₂)ₘ-. Other compounds and other groups are referred in the same way.

Further, symbols in groups have the same meanings as mentioned above unless otherwise specified.

The present invention provides a material for a resist protective film for immersion lithography (hereinafter also referred to as the material for a protective film of the present invention), which comprises a polymer (F) containing the repeating units (F^{U}) formed by polymerization of the polymerizable compound (f^{m}) having a fluoroine-containing bridged cyclic structure, and which has an ability to increase the alkali solubility by an action of an acid.

The material for a protective film of the present invention is excellent in the liquid repellency, especially in the dynamic liquid repellency, and particularly excellent in the water repellency, especially in the dynamic water repellency. The reason is not clearly understood, but is considered to be such that the polymer (F) contained in the material for a protective film of the present invention is a polymer having a bulky structure derived from a florine-containing bridged cyclic structure, and such a polymer is readily aligned on the outermost surface at the time of forming a coating film, as compared with a fluoropolymer having an acyclic fluorine-containing structure. Accordingly, by the present invention it is possible to readily prepare a material for a resist protective film which facilitates sliding of the immersion fluid and hardly be penetrated by the immersion fluid.

The polymerizable compound (f^{m}) in the present invention is preferably a compound having a monovalent polymerizable group and a monovalent fluorine-containing bridged cyclic hydrocarbon group.

The monovalent polymerizable group is preferably a monovalent group having a polymerizable carbon atom-carbon atom double bond, more preferably a vinyl group, a (meth)acryloyloxy group, a 2-fluoro-acryloyloxy group or a 2-fluoroalkyl-acryloyloxy group, particularly preferably a (meth)acryloyloxy group. Here, the (meth)acryloyloxy group means an acryloyloxy group or a methacryloyloxy group (the same applies hereinafter).

The monovalent fluorine-containing bridged cyclic hydrocarbon group is preferably an aliphatic group, particularly preferably a saturated aliphatic group. Further, between carbon atom-carbon atom in the monovalent fluorine-containing bridged cyclic hydrocarbon group, -O-, -C(O)O- or -C(O)- may be introduced.
Further, to a carbon atom of the monovalent fluorine-containing bridged cyclic hydrocarbon group, a group containing a hydroxyl group or a carboxyl group may be bonded.

The monovalent fluorine-containing bridged cyclic hydrocarbon group is a monovalent group obtained by removing a hydrogen atom from a bridged cyclic saturated hydrocarbon compound, preferably a group in which at least 50% of remaining hydrogen atoms are substituted by fluorine atoms. More preferably, at least 80% of such remaining hydrogen atoms are substituted by fluorine atoms, and particularly preferably, all of them are substituted by fluorine atoms.

The bridged cyclic saturated hydrocarbon compound is preferably a bridged cyclic saturated hydrocarbon compound selected from the group consisting of the following compound (1) and the following compound (2):

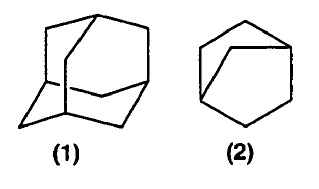

The polymerizable compound (f^{m}) in the present invention is particularly preferably the compound (f) selected from the group consisting of the following compound (f1), the following compound (f2), the following compound (f3) and the following compound (f4):

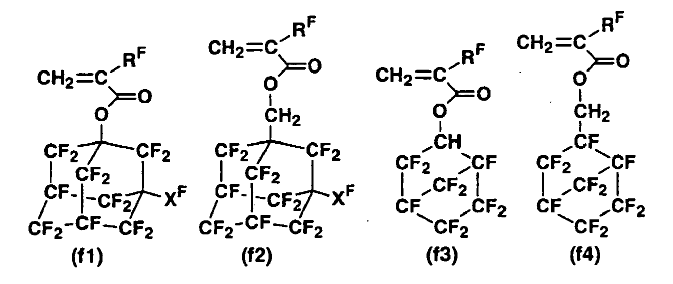

In the compound (f) having an asymmetric carbon, a configuration of an asymmetric center may be an endo form or an exo form.

R^{F} is preferably a hydrogen atom or a methyl group.

X^{F} is preferably a fluorine atom.

As specific examples of the polymerizable compound (f^{m}), the following compounds may be mentioned.

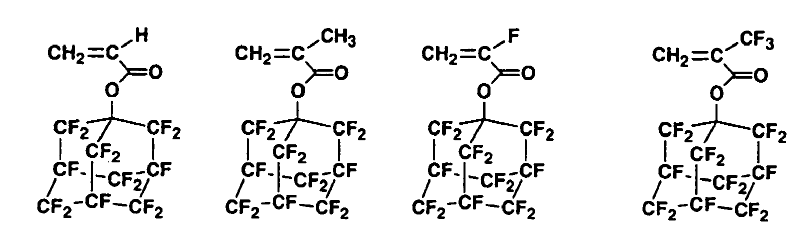

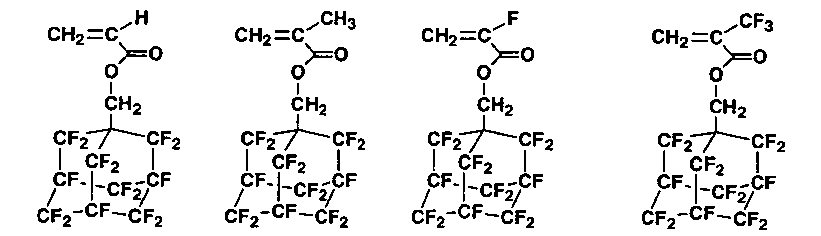

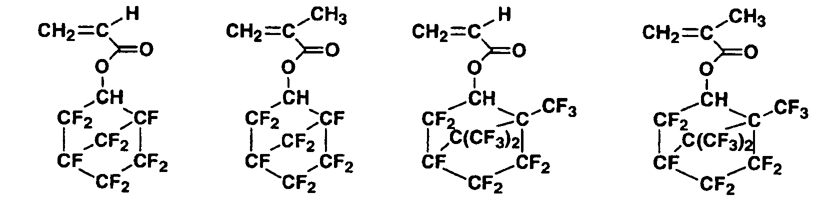

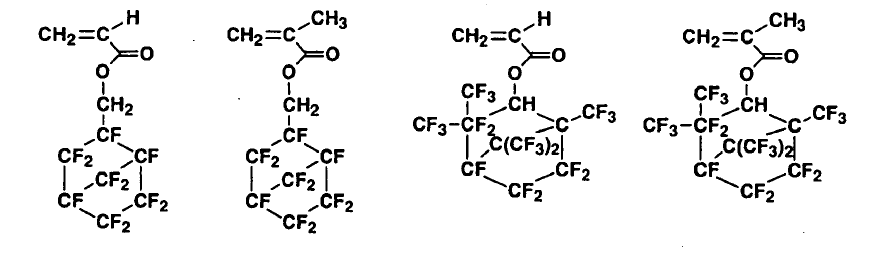

The compound (f2), the compound (f3) and the compound (f4) are novel compounds. Processes for their production will be described hereinafter.

The weight average molecular weight of the polymer (F) in the present invention is preferably from 1,000 to 100,000, particularly preferably from 1,000 to 50,000.

The present invention provides a polymer (hereinafter referred to as "the protective film polymer of the present invention") for an alkali soluble resist protective film for immersion lithography, which comprises the polymer (FB) containing the repeating units (F^{U}) formed by polymerization of the polymerizable compound (f^{m}) having a fluorine-containing bridged cyclic structure and the repeating units (B^{U}) formed by polymerization of a polymerizable compound (b^{m}) having a hydroxyl group, a carboxyl group, a sulfonic acid group, a sulfonyl amide group, an amino group or a phosphoric acid group.

The protective film polymer of the present invention is excellent in the liquid repellency, more excellent in the dynamic liquid repellency, and particularly excellent in the water repellency, furthermore excellent in the dynamic water repellency. The reason is not clearly understood, but is considered to be such that the protective film polymer of the present invention is made of the polymer (FB) having a bulky structure derived from a fluorine-containing bridged cyclic structure, and such a polymer is readily aligned on the outermost surface during forming a coating film, as compared with a fluoropolymer having an acyclic fluorine-containing structure. Accordingly, in an immersion lithography method using a resist protective film prepared from the protective film polymer of the present invention, the immersion fluid readily follows a projector lens which moves over the resist protective film at a high speed. Further, the protective film polymer of the present invention is an alkali soluble polymer since such a polymer contains the repeating units (B^{U}). It is possible to remove a resist protective film prepared from the protective film polymer of the present invention, by an alkaline solution. Accordingly, by employing the protective film polymer of the present invention, it is possible to stably conduct a high-speed immersion lithography method which is capable of transferring a pattern image of a mask with high resolution.

The polymerizable compound (b^{m}) in the present invention is preferably a polymerizable monomer having a hydroxyl group or a carboxyl group. The hydroxyl group may be an alcoholic hydroxyl group or a phenolic hydroxyl group.

From the viewpoint of the water repellency or the alkaline affinity, the polymerizable compound (b^{m}) is more preferably a polymerizable compound having a hydroxyl group or a carboxyl group bonded to a carbon atom adjacent to a carbon atom having a polyfluoroalkyl group bonded thereto, particularly preferably a polymerizable compound having -C(CF₃)(OH)-, -C(CF₃)₂(OH) or -C(O)OH.

The polymerizable compound (b^{m}) is preferably a compound (b) selected from the group consisting of the following compound (b1), the following compound (b2), the following compound (b3) and the following compound (b4), particularly preferably the compound (b1).

CF₂=CF-Q^{B1}-CH=CH₂ (b1)

CH₂=CR^{B2}-C(O)O-Q^{B2}(-C(CF₃)₂OH)_{b} (b2)

CH₂=CH-Q^{B3}(-C(CF₃)₂OH)_{b} (b3)

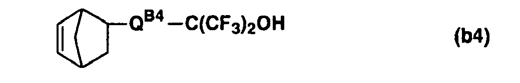

In Q^{B1} of the compound (b1), m is preferably 1. In Q^{B1}, is preferably 0.

Q^{B1} is preferably -CF₂C(CF₃)(OH)CH₂-,
-CH₂CH(C(CF₃)₂(OH))CH₂- or -CH₂CH(C(O)OH)CH₂-.

As specific examples of the compound (b1), the following compounds maybe mentioned.
CF₂=CFCF₂C(CF₃)(OH)CH₂CH=CH₂,
CF₂=CFCH₂CH(C(CF₃)₂(OH))CH₂CH=CH₂,
CF₂=CFCH₂CH(CH₂C(CF₃)₂(OH))CH₂CH=CH₂,
CF₂=CFCH₂CH(C(O)OH)CH₂CH=CH₂.

A polymer containing repeating units formed by polymerizing the compound (b1) is a polymer having a fluorine-containing cyclic structure in its main chain, having -C(CF₃)(OH)-, -C(CF₃)₂(OH) or -CH(C(O)OH)-, which is particularly excellent in the alkaline affinity and the dynamic water repellency.

(b+1) valent hydrocarbon groups in Q^{B2} of the compound (b2) and Q^{B3} of the compound (b3) are each independently preferably a C₁₋₂₀ (b+1) valent cyclic hydrocarbon group. The above cyclic hydrocarbon group may be a group made solely of a cyclic hydrocarbon group, or may be a group containing a cyclic hydrocarbon group therein. The above cyclic hydrocarbon group may be an aliphatic group or an aromatic group. Further, the above cyclic hydrocarbon group may be a monocyclic hydrocarbon group or a polycyclic hydrocarbon group. The polycyclic hydrocarbon group may be a bridged cyclic hydrocarbon group.

Q^{B2} of the compound (b2) and Q^{B3} of the compound (b3) are particularly preferably any one of the following groups.

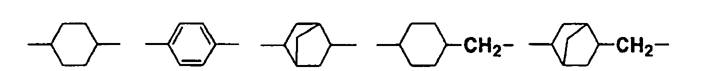

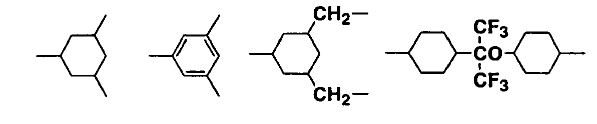

As specific examples of the compound (b2), the following compounds may be mentioned.

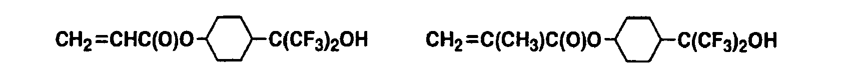

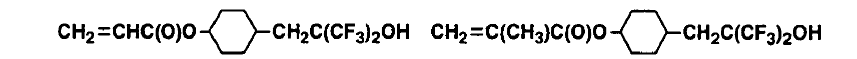

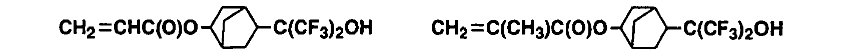

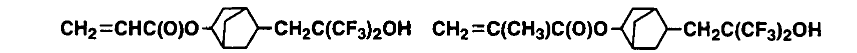

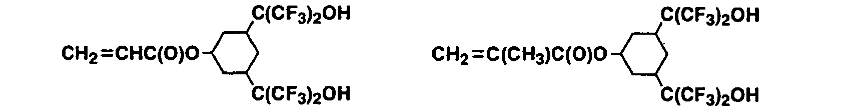

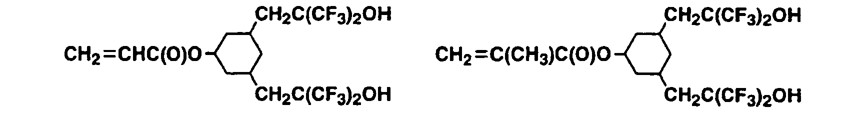

As specific examples of the compound (b3), the following compounds may be mentioned.

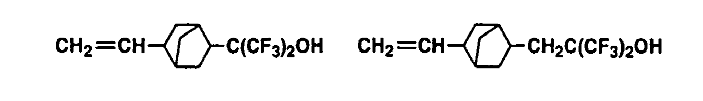

Q^{B4} of the compound (b4) is preferably a single bond or a methylene group.

As specific examples of the compound (b4), the following compounds may be mentioned.

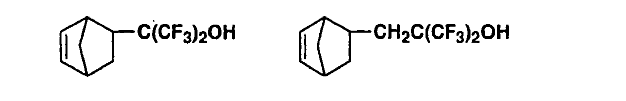

The protective film polymer of the present invention may be a polymer made solely of repeating units (F^{U}) and repeating units (B^{U}), or a polymer further containing other repeating units. Further, the repeating units (F^{U}) in the protective film polymer of the present invention may be one type or two or more types. Further, the repeating units (B^{U}) in the protective film polymer of the present invention may be one type or two or more types.

The protective film polymer of the present invention contains repeating units (F^{U}) in an amount of preferably from 1 to 50 mol%, more preferably from 1 to 20 mol%, particularly preferably from 3 to 15 mol%, based on the total amount of repeating units. The protective film polymer of the present invention contains repeating units (B^{U}) in an amount of from 50 to 99 mol%, more preferably from 80 to 99 mol%, particularly preferably from 85 to 97 mol%, based on the total amount of repeating units.

The weight average molecular weight of the protective film polymer of the present invention is preferably from 1,000 to 100,000, particularly preferably from 1,000 to 50,000.

A preferred embodiment of the protective film polymer of the present invention may be a polymer which is made solely of the repeating units (F^{U}) and the repeating units (B^{U}), and which contains from 1 to 50 mol% of the repeating units (F^{U}) and from 50 to 99 mol% of the repeating units (B^{U}), based on the total amount of repeating units. A more preferred embodiment may be a polymer which contains from 3 to 15 mol% of repeating units (F^{U}) and from 87 to 99 mol% of repeating units (B^{U}), based on the total amount of repeating units.

Repeating units (B^{U}) in the above embodiment are preferably repeating units formed by polymerizing a polymerizable compound having -C(CF₃)(OH)-, -C(CF₃)₂(OH) or -C(O)OH, more preferably repeating units formed by polymerizing the compound (b) selected from the group consisting of the compound (b1), the compound (b2), the compound (b3) and the compound (b4), particularly preferably repeating units formed by polymerizing the compound (b1), most preferably repeating units formed by polymerizing CF₂=CFCF₂C(CF₃)(OH)CH₂CH=CH₂,
CF₂=CFCH₂CH(C(CF₃)₂(OH))CH₂CH=CH₂ or
CF₂=CFCH₂CH(C(O)OH)CH₂CH=CH₂.

The weight average molecular weight of the polymer in the above embodiment is preferably from 1,000 to 30,000.

In an application to an immersion lithography method, the protective film polymer of the present invention is usually used as applied on the surface of a photosensitive resist film formed on the substrate, whereby it is preferred that such a polymer is prepared to be a liquid composition.

The present invention provides a composition (hereinafter also referred to as "protective film-forming composition (1)") for forming a resist protective film for immersion lithography, comprising the protective film polymer of the present invention and an organic solvent.

The protective film-forming composition (1) preferably contains from 100 mass% to 10,000 mass% of an organic solvent based on the total mass of the protective film polymer of the present invention.

The organic solvent is not particularly limited so long as it is a solvent having high compatibility with the protective film polymer of the present invention.
The organic solvent may be a fluorinated organic solvent or a non-fluorinated organic solvent.

As a specific example of the fluorinated organic solvent, a hydrochlorofluorocarbon such as CCl₂FCH₃, CF₃CF₂CHCl₂ or CClF₂CF₂CHClF; a hydrofluorocarbon such as CF₃CHFCHFCF₂CF₃, CF₃(CF₂)₅H, CF₃(CF₂)₃C₂H₅, CF3(CF₂)₅C₂H₅ or CF₃(CF₂)₇C₂H₅; a hydrofluorobenzene such as 1,3-bis(trifluoromethyl)benzene or methaxylene hexafluoride; a hydrofluoroketone; a hydrofluoroalkylbenzene; a hydrofluoroether such as CF₃CF₂CF₂CF₂OCH₃, (CF₃)₂CFCF(CF₃)CF₂OCH₃ or CF₃CH₂OCF₂CHF₂; or a hydrofluoroalcohol such as CHF₂CF₂CH₂OH, may be mentioned.

As a specific example of the non-fluorinated organic solvent, an alcohol such as methyl alcohol, ethyl alcohol, diacetone alcohol, 2-propanol, 1-butanol, 2-butanol, 2-methyl-1-propanol, 2-ethylbutanol, pentanol, hexanol or heptanol; a ketone such as acetone, methyl isobutyl ketone, cyclohexanone, cyclopentanone, 2-heptanone, N-methylpyrrolidone or γ-butyrolactone; an ester such as propylene glycol monomethyl ether acetate, propylene glycol monomethyl ether propionate, propylene glycol monoethyl ether acetate, carbitol acetate, methyl 3-methoxypropionate, ethyl 3-ethoxypropionate, methyl β-methoxyisobutyrate, ethyl butyrate, propyl butyrate, methyl isobutyl ketone, ethyl acetate, 2-ethoxyethyl acetate, isoamyl acetate, methyl lactate or ethyl lactate; an aromatic hydrocarbon such as toluene or xylene; glycol monoalkyl ether or a glycol dialkyl ether such as propylene glycol monomethyl ether, propylene glycol methyl ether acetate, propylene glycol monoethyl ether, ethylene glycol monoisopropyl ether, diethylene glycol monomethyl ether, diethylene glycol dimethyl ether or propylene glycol monomethyl ether; N,N-dimethylformamide or N,N-dimethylacetamide, may be mentioned.

The protective film-forming composition (1) may also contain a component other than the protective film polymer of the present invention and the organic solvent. As a specific example of such a component, a plasticizer, a stabilizer, a colorant or an antihalation agent may be mentioned.

The present invention provides a composition (hereinafter, also referred to as "protective film composition of the present invention") for an alkali soluble resist protective film for immersion lithography, which comprises the polymer (F) containing the repeating units (F^{U}) formed by polymerization of the polymerizable compound (f^{m}) having a fluorine-containing bridged cyclic structure and the polymer (B) containing the repeating units (B^{U}) formed by polymerization of a polymerizable compound (b^{m}) having a hydroxy group, a carboxyl group, a sulfonic acid group, a sulfonylamide group, an amino group or a phosphoric acid group.

The protective film composition of the present invention is excellent in liquid repellency, especially in the dynamic liquid repellency, and particularly excellent in the water repellency, especially in the dynamic water repellency. The reason is not clearly understood, but is considered to be such that the polymer (F) contained in the protective film composition of the present invention is a polymer having a bulky structure derived from a fluorine-containing bridged cyclic structure, and such a polymer is readily aligned on the outermost surface during forming a coating film as compared with a fluoropolymer having an acyclic fluorine-containing structure. Accordingly, in an immersion lithography method employing a resist protective film prepared from the protective film composition of the present invention, the immersion fluid readily follows a projector lens which moves over the resist protective film at a high speed. Further, the protective film composition of the present invention is an alkali soluble composition since it contains the polymer (B). It is possible to readily remove a resist protective film prepared from the protective film composition of the present invention by an alkaline solution. Accordingly, by employing the protective film composition of the present invention, it is possible to stably conduct a high-speed immersion lithography method which is capable of transferring a pattern image of a mask with high resolution.

The polymer (F) (hereinafter, also referred to as "polymer (FS)") in the protective film composition of the present invention may be a polymer made solely of the repeating units (F^{U}), or may be a polymer containing repeating units (hereinafter, also referred to as "other repeating units (FS^{U})") other than the repeating units (F^{U}). In any case, the polymer (FS) contains the repeating units (F^{U}) in an amount of at least 1 mol%, preferably at least 10 mol%, particularly preferably at least 20 mol%, based on the total amount of repeating units. In a case where the polymer (FS) contains other units (FS^{U}), the other units (FS^{U}) are contained in an amount of preferably at most 90 mol%, particularly preferably at most 50 mol%, based on the total amount of repeating units.

Such other units (FS^{U}) are not particularly limited, but are preferably the repeating units (B^{U}) formed by polymerization of the polymerizable compound (b^{m}), more preferably repeating units formed by polymerization of a polymerizable compound having -C(CF₃)(OH)-, -C(CF₃)₂(OH) or -C(O)OH, particularly preferably repeating units formed by polymerization of the compound (b) selected from the group consisting of the compound (b1), the compound (b2), the compound (b3) and the compound (b4), most preferably repeating units formed by polymerization of the compound (b1).

The weight average molecular weight of the polymer (FS) is preferably from 1,000 to 100,000, particularly preferably from 1,000 to 50,000.

As a preferred embodiment of the polymer (FS), the following polymer (FS^{H}), the following polymer (FS^{C1}) or the following polymer (FS^{C2}) may be mentioned.

Polymer (FS^{H}): A polymer made solely of the repeating units (F^{U})_{.}

Polymer (FS^{C1}): A polymer containing the repeating units (F^{U}) and such other units (FS^{U}), wherein the repeating units (F^{U}) are contained in an amount of from 10 to 70 mol% and such other units (FS^{U}) are contained in an amount of from 30 to 90 mol%, based on the total amount of repeating units.

Such other units (FS^{U}) in the polymer (FS^{C1}) are preferably repeating units (B^{U}) formed by polymerization of the polymerizable compound (b^{m}), more preferably repeating units formed by polymerization of a polymerizable compound having -C(CF₃)(OH)-, -C(CF₃)₂(OH) or -C(O)OH, particularly preferably repeating units formed by polymerization of the compound (b1).

Polymer (FS^{C2}): A polymer containing the repeating units (F^{U}) and such other units (FS^{U}), wherein the repeating units (F^{U}) are contained in an amount of from 1 to 25 mol% and such other units (FS^{U}) are contained in an amount of from 75 to 99 mol%, based on the total amount of repeating units.

Such other units (FS^{U}) in the polymer (FS^{C2}) are preferably the repeating units (B_{U}) formed by polymerization of the polymerizable compound (b^{m}), more preferably repeating units formed by polymerization of a polymerizable compound having -C(CF₃)(OH)-, -C(CF₃)₂(OH) or -C(O)OH, particularly preferably repeating units formed by polymerization of the compound (b1).

The weight average molecular weight of the polymer in such a preferred embodiment is preferably from 1,000 to 30,000.

In the polymer (B), a preferred embodiment of the repeating units (B^{U}) formed by polymerization of the polymerizable compound (b^{m}) is the same as in the resist protective film polymer of the present invention.

The polymer (B) may be a polymer made solely of the repeating units (B^{U}), or may be a polymer further containing other units. Further, the polymer (B) may be made solely of one type of the repeating units (B^{U}) or may be made of at least two types of the repeating units (B^{U}). The polymer (B) particularly preferably contains at least 50 mol% of the repeating units (B^{U}) based on the total amount of repeating units.

The weight average molecular weight of the polymer (B) is preferably from 1,000 to 100,000, particularly preferably from 1,000 to 50,000.

As a preferred embodiment of the polymer (B), a polymer containing the repeating units (B^{U}), which is a polymer containing from 70 to 100 mol% of the repeating units (B^{U}) based on the total amount of repeating units, may be mentioned. As a particularly preferred embodiment, a polymer made solely of the repeating units (B^{U}) may be mentioned.

A preferred embodiment of the repeating units (B^{U}) in the polymer of the above embodiment is preferably the repeating units (B^{U}) formed by polymerization of the polymerizable compound (b^{m}), more preferably repeating units formed by polymerization of a polymerizable compound having -C(CF₃)(OH)-, -C(CF₃)₂(OH) or -C(O)OH, particularly preferably repeating units formed by polymerization of the compound (b1).

The weight average molecular weight of the polymer having the above embodiment is preferably from 1,000 to 50,000.

The protective film composition of the present invention contains the polymer (FS) and the polymer (B), and further the polymer (FS) is contained in an amount of preferably from 0.1 to 30 mass%, particularly preferably from 1 to 10 mass%, based on the polymer (B). In such a case, the polymer (B) and the polymer (FS) are readily compatible with each other, and there is an effect that the film-forming property of the protective film will be excellent.

Further, another preferred embodiment of the protective film composition of the present invention may be an embodiment in which the polymer (FS) is contained in an amount of more than 30 mass% and at most 200 mass% to the polymer (B). In this embodiment, it is preferred that the polymer (FS) is contained in an amount of from 50 to 150 mass% to the polymer (B). In such a case, the dynamic water repellency and the alkali solubility of the protective film composition of the present invention is particularly high. The polymer (FS) in such a case is preferably a polymer (FS^{C2}).

In an application to an immersion lithography method, the protective film composition of the present invention is usually used as applied on the surface of a photosensitive resist film formed on a substrate, and therefore it is preferred that such a protective film composition is prepared to be a liquid composition. The present invention provides a composition (hereinafter referred to also as "protective film-forming composition (2)") for forming a resist protective film for immersion lithography, comprising the protective film composition of the present invention and an organic solvent.

It is preferred that the protective film-forming composition (2) contains from 100 mass% to 10,000 mass% of an organic solvent based on the total mass of the protective film composition of the present invention.

The organic solvent is not particularly limited so long as it is a solvent having a high compatibility with the protective film composition of the present invention. As a specific example of the organic solvent, the same organic solvent as the organic solvent for the protective film-forming composition (1) may be mentioned.

The protective film-forming composition of the present invention (which is a general term for the protective film-forming composition (1) and the protective film-forming composition (2)) is used for a protective film material for a photosensitive resist in an immersion lithography method. The immersion lithography method may be a method for forming a resist pattern on a substrate, which comprises sequentially carrying our a step of applying a photosensitive resist material on a substrate to form a photosensitive resist film on the substrate, a step of applying the protective film-forming composition of the present invention on the surface of the photosensitive resist film to form a resist protective film on the surface of the photosensitive resist film, a step of immersion lithography, and a step of development.

The photosensitive resist material is not particularly limited so long as it is a photosensitive resist material containing a polymer for increasing an alkali solubility by an action of acid and a photoacid generator. As a specific example of the photosensitive resist material, a photosensitive resist material described in JP-A-2005-234178 may be mentioned. As a more specific example of the photosensitive resist material, a photosensitive resist composition containing triphenylsulfonium triflate as a photoacid generator and further containing a copolymer made of the following three compounds as the above polymer, may be mentioned.

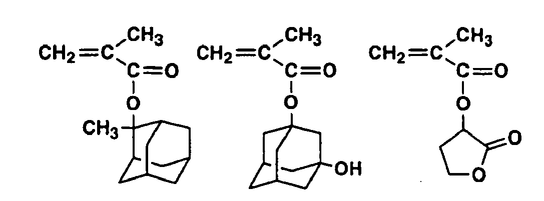

The immersion lithography step may be a step in which a pattern image of a mask obtained by irradiating a mask with light of an exposure light source is projected on a desired position of a resist film on a substrate via a projector lens which relatively moves over the resist film while the immersion fluid fills a space between the projector lens and the resist film.

The exposure light source is preferably g-line (wavelength: 436 nm), i-line (wavelength: 365 nm), KrF excimer laser (wavelength: 248 nm), ArF excimer laser (wavelength: 193 nm) or F₂ excimer laser (wavelength: 157 nm), more preferably ArF excimer laser or F₂ excimer laser, particularly preferably ArF excimer laser.

The immersion fluid may be an oily liquid medium (such as decalin) or an aqueous liquid medium (such as ultrapure water), preferably a liquid medium containing water as a main component, particularly preferably ultrapure water.

The development step may be a step of removing a resist protective film and an exposed portion of the resist film with an alkaline solution. The alkaline solution is not particularly limited, but may be an aqueous alkaline solution containing an alkali compound selected from the group consisting of sodium hydroxide, potassium hydroxide, ammonium hydroxide, tetramethylammonium hydroxide and triethylamine.

The present invention provides a polymer (hereinafter referred to as "protective film polymer (P)") for a resist protective film for liquid immersion exposure, containing the repeating units (F^{p}) formed by polymerization of a compound represented by the following compound (f^{p}) and the repeating units (B^{p}) formed by polymerization of a polymerizable compound (b^{p}) having a polar group selected from the group consisting of a hydroxyl group, a carboxyl group, a sulfonic acid group, a sulfonyl amide group, an amino group and a phosphoric acid group.

CH₂=CR^{fp}C(O)O-X^{p} (f^{p})

wherein, the symbols have the following meanings (the same applies hereinafter).

R^{fp}: A hydrogen atom, a fluorine atom, a C₁₋₃ alkyl group or a C₁₋₃ fluoroalkyl group.

X^{p}: A group containing a C₅₋₂₀ fluorine-containing cyclic hydrocarbon group. Further, to a carbon atom in X^{p}, a hydroxyl group, a carboxyl group or a C₁₋₁₀ group selected from the group consisting of an alkoxy group, an alkoxyalkoxy group, an alkoxycarbonyl group and an alkylcarbonyl group may be bonded.

The protective film polymer (P) of the present invention is excellent in the water repellency, especially in the dynamic water repellency. The reason is not necessarily clearly understood, but is considered to be such that the protective film polymer (P) is a polymer having, in a side chain, a bulky fluorine-containing group (a group represented by the formula -X^{p}) derived from the compound (f^{p}). Accordingly, it is considered that the protective film polymer (P) has a high water repellency and thus is hardly penetrated by water, and is particularly excellent in the dynamic water repellency, whereby water readily slides thereon.

R^{fp} of the compound (f^{p}) is preferably a hydrogen atom or a methyl group.

X^{p} of the compound (f^{p}) is not particularly limited so long as it is a group containing a monovalent fluorine-containing cyclic hydrocarbon group, but may be a group made solely of a fluorine-containing cyclic hydrocarbon group, or a group formed by bonding a fluorine-containing cyclic hydrocarbon group to CH²=CR^{fp}C(O)O- via a connecting group.

The fluorine-containing cyclic hydrocarbon group in the protective film polymer (P) may be a fluorine-containing monocyclic hydrocarbon group or a fluorine-containing polycyclic hydrocarbon group, and from the viewpoint of its sterically bulky structure and more excellent dynamic water repellency, a fluorine-containing polycyclic hydrocarbon group is preferred.

Further, the fluorine-containing cyclic hydrocarbon group may be an aliphatic group or an aromatic group, but from the viewpoint of the water repellency, an aliphatic group is preferred, and an saturated aliphatic group is particularly preferred.

The fluorine content of the fluorine-containing cyclic hydrocarbon group is preferably at least 30 mass%, particularly preferably at least 50 mass% from the viewpoint of the water repellency. The upper limit of the above fluorine content is not particularly limited, but is preferably at most 76 mass%.

Further, in a case where a hydroxyl group, a carboxyl group or a C₁₋₁₀ group which is a group selected from the group consisting of an alkoxy group, an alkoxyalkoxy group, an alkoxycarbonyl group and an alkylcarbonyl group is bonded to a carbon atom in the fluorine-containing cyclic hydrocarbon group, it is preferred that a hydroxyl group or -OCH₂OX^{fpp} (wherein X^{fpp} is a C₁₋₉ alkyl group) is bonded to the above carbon atom, and it is particularly preferred that a hydroxyl group, -OCH₂OCH₂CH₃, -OCH₂OCH₃ or -OCH₂OC(CH₃)₃ is bonded thereto.

The fluorine-containing polycyclic hydrocarbon group is preferably a C₅₋₂₀ fluorine-containing condensation polycyclic hydrocarbon group, but from the viewpoint of its sterically bulky structure, a C₅₋₂₀ fluorine-containing bridged cyclic hydrocarbon group is particularly preferred.

The fluorine-containing bridged cyclic hydrocarbon group is preferably a group containing a fluoroadamantyl group or a group containing a fluoronorbornyl group, but from the viewpoint of the sterically bulky structure, the former group is more preferred, and any of the groups represented by the following formulae is particularly preferred.

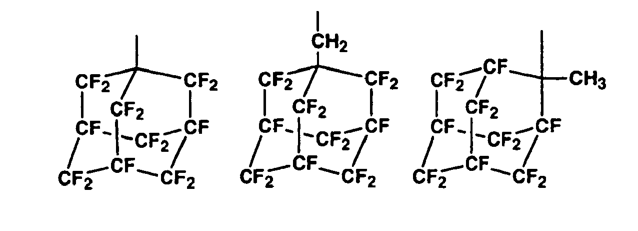

The compound (f^{p}) is preferably the following compound (f1^{p}), particularly preferably the following compound (f1^{0p}) or the following compound (f1^{0p}). 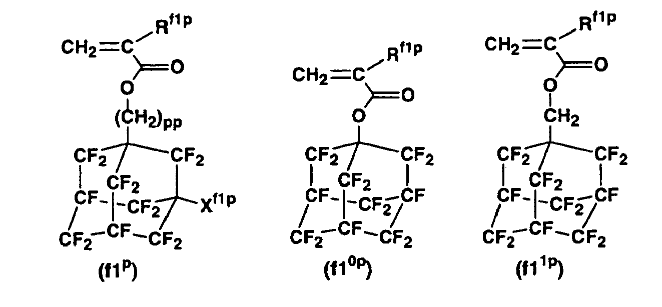 wherein the symbols have the following meanings (the same applies hereinafter).

R^{f1p}_{:} A hydrogen atom, a fluorine atom, a methyl group or a trifluoromethyl group.

pp: 0 or 1.

X^{f1p}: A fluorine atom or a hydroxyl group when pp is 0, or a fluorine atom or a hydroxymethyl group when pp is 1.

When pp is 1, the compound (f1^{p}) is a novel compound. It is possible to produce the compound (f1^{p}) in such a manner that the following compound (f1-3^{p}) is reacted with water to obtain the following compound (f1-2^{p}), then the compound (f1-2^{p}) is reacted with H-CHO to obtain the following compound (f1-1^{p}), and then the compound (f1-1^{p}) is reacted with CH₂=CR^{f1p}COCl. 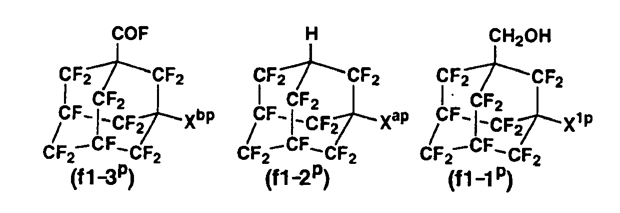 wherein X^{bp} represents a fluorine atom when X^{1p} is a fluorine atom, or a fluorocarbonyl group when X^{1p} is a hydroxymethyl group, and X^{ap} represents a fluorine atom when X^{1p} is a fluorine atom, or a hydrogen atom when X^{1p} is a hydroxymethyl group.

As a specific example of the compound (f^{p}), a compound described in the specific example of the polymerizable compound (f^{m}) may be mentioned.

The protective film polymer (P) of the present invention is dissolved in an alkaline solution by interaction with an alkali since such a polymer contains the repeating units (B^{p}). Accordingly, it is possible to readily remove the protective film polymer (P) by an alkaline solution after a liquid-immersion exposure step in a liquid immersion lithography method.

A hydroxyl group in the polymerizable compound (b^{p}) may be an alcoholic hydroxyl group or a phenolic hydroxyl group.

From the viewpoint of the water repellency and the affinity with an alkaline solution of the polymer, the polymerizable compound (b^{p}) is more preferably a polymerizable monomer having a hydroxyl group or a carboxyl group bonded to a carbon atom adjacent to a carbon atom having a polyfluoroalkyl group bonded thereto, particularly preferably -C(C_{q}F_{2pq+1})(OH) -, -C(C_{qp}F_{2qp+1})₂(OH) (wherein qp represents an integer of from 1 to 6.) or a carboxyl group, most preferably a polymerizable compound having -C(CF₃)(OH)-, -C(CF₃)₂(OH) or -C(O)OH.

As preferred examples of the polymerizable compound (b^{p}), the following compounds (b1^{p}) to (b4^{p}) may be mentioned.

CF₂=CF-Q^{Bp}-CR^{B1p}=CH₂ (b1^{p})

CH₂=CR^{B2p}C(O)O-Q^{B2p}(-C(CF₃)₂OH)_{bp} (b2^{p})

CH₂=CH-Q^{B3p}(-C(CF₃)₂OH)_{bp} (b3^{p})

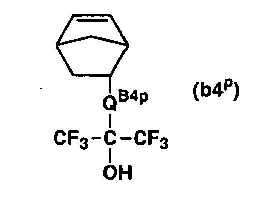

wherein the symbols have the following meanings (the same applies hereinafter).

R^{B1p}: A hydrogen atom or a C₁₋₁₂ alkyl group.
Q^{Bp}: -CF₂C(CF₃)(OH)(CH₂)ₘₚ-,
-CH₂CH((CH₂)ₚₚC(CF₃)₂(OH))(CH₂)ₙₚ- or
-CH₂CH((CH₂)ₚₚₚC(CF₃)₂(C(O)OH))(CH₂)ₙₚ-.
mp, np and ppp: Each independently 0, 1 or 2.
R^{B2p}: A hydrogen atom, a fluorine atom, a C₁₋₃ alkyl group or a C₁₋₃ fluoroalkyl group.

Q^{B2p} and Q^{B3p}: Each independently a C₁₋₂₀ (bp+1) valent hydrocarbon group which may contain a fluorine atom.

bp: 1 or 2.

Q^{B4p}: A C₁₋₁₀ bivalent hydrocarbon group which may contain a single bond or a fluorine atom.

As a specific example of the polymerizable compound (b^{p}), a compound described in the specific example of the polymerizable compound (b^{m}) may be mentioned.

The protective film polymer (P) of the present invention may be a polymer made solely of the repeating units (F^{p}) and the repeating units (B^{p}), or may be a polymer made of the repeating units (F^{p}), the repeating units (B^{p}) and repeating units other than the repeating units (F^{p}) and the repeating units (B^{p}) (hereinafter also referred to as "other units (F^{p})").

The repeating units (F^{p}) may be made solely of one type or may be made of two or more types. Further, the repeating units (B^{p}) may be made solely of one type, or may be made of two or more types.

Such other units (F^{p}) are not particularly limited, but are preferably repeating units formed by polymerization of a polymerizable compound having an acid anhydride group, particularly preferably repeating units formed by polymerization of the following compound.

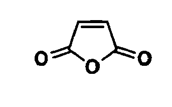

The protective film polymer (P) of the present invention contains the repeating units (F^{p}) in an amount of preferably from 1 to 25 mol%, particularly preferably from 3 to 15 mol%, based on the total amount of repeating units. The protective film polymer (P) contains the repeating units (B^{p}) in an amount of preferably from 50 to 99 mol%, more preferably from 75 to 99 mol%, particularly preferably from 85 to 97 mol%, based on the total amount of repeating units.

In a case where the protective film polymer (P) contains such other units (F^{p}), the protective film polymer (P) preferably contains such other units (F^{p}) in an amount of from 5 to 20 mol% based on the total amount of repeating units.

The weight average molecular weight of the protective film polymer (P) is preferably from 1,000 to 50,000, particularly preferably from 3,000 to 30,000.

The preferred embodiment of the protective film polymer (P) may be a polymer made solely of the repeating units (F^{p}) and the repeating units (B^{p}), wherein the repeating units (F^{p}) are contained in an amount of from 3 to 15 mol% and the repeating units (B^{p}) are contained in an amount of from 85 to 97 mol%, based on the total amount of repeating units, and further the polymer has a weight average molecular weight of from 3,000 to 30,000.

The repeating units (F^{p}) in the above preferred embodiment are preferably repeating units formed by polymerization of the compound (f1^{0p}) or the compound (f1^{1P}). The repeating units (B^{p}) are preferably repeating units formed by polymerization of the compound (b1^{p}) or the compound (b3^{p}), more preferably repeating units formed by cyclopolymerization of the compound (b1^{p}), particularly preferably repeating units formed by cyclopolymerization of CF₂=CF-CF₂C(CF₃)(OH)CH₂-CH=CH₂, CF₂=CF-CH₂CH(C(CF₃)₂(OH))CH₂-CH=CH₂, CF₂=CF-CH₂CH(CH₂C(CF₃)₂(OH))CH₂-CH=CH₂ or CF₂=CF-CH₂CH(C(O)OH)CH₂-CH=CH₂.

The production process of the protective film polymer (P) is not particularly limited, but may be a method of a radical polymerization of the compound (f^{p}) and the polymerizable compound (b^{p}) in the presence of a radical initiator.

The radical initiator is not particularly limited, but may be a peroxide such as benzoyl peroxide, diisopropyl peroxydicarbonate, di t-butyl peroxydicarbonate, t-butyl peroxypivalate, perfluorobutyryl peroxide, perfluorobenzoyl peroxide; an azo compound such as azoisobisbutyronitrile; or a persulfate.

The method of a radical polymerization is not particularly limited, but a bulk polymerization, a solution polymerization, a suspension polymerization or an emulsion polymerization may be employed.

A solvent in a case of carrying out the radical polymerization in the presence of the solvent, is not particularly limited, but may be an aliphatic hydrocarbon such as pentane, hexane or heptane; a hydrocarbon type alcohol such as methanol, ethanol, n-propanol, isopropanol or t-butanol; a hydrocarbon type ketone such as acetone, methyl ethyl ketone, methyl isobutyl ketone or cyclohexanone; a hydrocarbon type ether such as dimethyl ether, diethyl ether, methyl ethyl ether, methyl t-butyl ether, diethylene glycol dimethyl ether or tetraethylene glycol dimethyl ether; an alicyclic hydrocarbon type ether such as tetrahydrofuran or 1,4-dioxane; a nitrile such as acetonitrile; a hydrocarbon type ester such as methyl acetate, ethyl acetate, propyl acetate, isopropyl acetate, butyl acetate, t-butyl acetate, methyl propionate or ethyl propionate; an aromatic hydrocarbon such as toluene or xylene; a chlorohydrocarbon such as methylene chloride, chloroform or carbon tetrachloride; a chlorofluorocarbon such as CCl₂FCClF₂, CCl₂FCH₃, CF₃CF₂CHCl₂, CClF₂CF₂CHClF; a hydrofluorocarbon such as CF₃(CF₂)₅H or CF₃(CF₂)₃C₂H₅; a fluoroether such as CHF₂CF₂OCH₃; or a fluoroalcohol such as CHF₂CF₂CH₂OH, CF₃CF₂CF₂CFHCF₂CH₂OH, CFHCF₂CF₂CF₂CH₂OH, CF₃CH₂OH or CF₃CH(OH)CF₃.

The reaction temperature in the radical polymerization is not particularly limited, but is preferably from 0 to 200°C, particularly preferably from 25 to 100°C. The reaction pressure in the radical polymerization may be any one of a reduced pressure condition, an atmospheric pressure and a pressurized condition, and preferably from 1 kPa to 100 MPa, particularly preferably from 10 kPa to 10 MPa.

Since the protective film polymer (P) of the present invention is usually applied on the surface of a photosensitive resist formed on a substrate (such as a silicon wafer) to be formed into a film, it is preferred that such a polymer is prepared to be a liquid composition from the viewpoint of the film-forming property.

The present invention provides a composition (hereinafter also referred to as "protective film-forming composition (P)") for a resist protective film for liquid immersion exposure, which contains the protective film polymer (P) and an organic solvent.

An organic solvent in the protective film-forming composition (P) is not particularly limited so long as it is a solvent having high compatibility with the protective film polymer (P). The specific example of an organic solvent is the same as an organic solvent in the protective film-forming composition (1). As the organic solvent, one type may be used, or two or more types may be used.

The organic solvent in the protective film-forming composition (P) is preferably an organic solvent essentially containing an alcohol (such as the above hydrofluoroalcohol or the above alcohol) which may contain a fluorine atom, particularly preferably an organic solvent containing from 0.01 to 100 mass% of an alcohol based on the total mass of the organic solvent.

The protective film-forming composition (P) preferably contains from 100 to 10,000 mass% of an organic solvent based on the total mass of the protective film polymer (P).

Further, the protective film-forming composition (P) may also contain a component other than the protective film polymer (P) and an organic solvent. A specific example of such a component is not particularly limited, but a plasticizer, a stabilizer, a colorant or an anti-halation agent may be mentioned.

The protective film-forming composition (P) is used for a liquid immersion lithography method. The liquid immersion lithography method is not particularly limited, but may be a liquid immersion lithography method which comprises sequentially carrying out a step of applying a photosensitive resist material on a substrate (such as a silicon wafer) to form a resist film on the substrate, a step of applying the protective film-forming composition (P) on the resist film to form a resist protective film on the resist film, a step of liquid immersion exposure, a step of development, a step of etching and a step of resist delamination.

The photosensitive resist material may be the same material as the photosensitive resist material described in the protective film-forming composition of the present invention.

The exposure light source in the present invention may also be the same light source as the exposure light source described in the protective film-forming composition of the present invention.

The step of liquid immersion exposure may be a step on which a pattern image of a mask obtained by irradiating a mask with light of the exposure light source is projected on a desired position of a resist film on a substrate via a projector lens which relatively moves over a resist protective film while a liquid medium fills a space between the projector lens and the resist protective film. The liquid medium is preferably a liquid medium containing water as a main component, particularly preferably ultrapure water.

In the step of liquid immersion exposure, a resist film is insulated from a liquid medium (such as water) by a protective film made of the protective film-forming composition (P), whereby the liquid medium hardly penetrates into the resist film, and further the component in the resist film is hardly eluted into the liquid medium. Accordingly, in the step of the liquid immersion exposure in the present invention, the resist film is hardly swelled, and the optical characteristics such as refractive index of the liquid medium hardly change. Further, in the step of the liquid immersion exposure in the present invention, water readily follows a projector lens which relatively moves over a resist protective film, whereby it is possible to stably conduct the step of liquid immersion exposure.

The step of development may be the same embodiment as in the step of development described in the protective film-forming composition of the present invention.

The present invention provides a composition (hereinafter referred to as "protective film composition (Q)") for a resist protective film for liquid immersion exposure, which contains the following polymer (F^{q}) and the following polymer (B^{q}), wherein the polymer (F^{q}) is contained in an amount of from 0.1 to 30 mass% based on the polymer (B^{q}).

Polymer (F^{q}): A polymer containing the repeating units (F^{p}) formed by polymerization of the compound (f^{p}), wherein the repeating units (F^{p}) is contained in an amount of at least 10 mol% based on the total amount of repeating units.

Polymer (B^{q}): An alkali soluble polymer containing repeating units (B^{p}) formed by polymerization of the polymerizable compound (b^{p}).

The polymer (F^{q}) in the protective film composition (Q) of the present invention is excellent in the water repellency, especially in the dynamic water repellency. The reason is not necessarily clearly understood, but is considered to be such that the polymer (F^{q}) is a polymer having, in a side chain, a bulky fluorine-containing group (a group represented by be formula -X^{p}) derived from the compound (f^{p}). Accordingly, it is considered that the protective film composition (Q) containing the polymer (F^{q}) is formed into a liquid immersion protective film which has high water repellency and thus is hardly penetrated, and further particularly excellent in the dynamic water repellency, whereby such a composition is formed into a liquid immersion protective film on which water readily slides.

The polymer (F^{q}) may be a polymer made solely of the repeating units (F^{p}), or may be a polymer containing the repeating units (F^{p}) and repeating units other than the repeating units (F^{p}) (hereinafter also referred to as "other units (F^{q})"). Further, the repeating units (F^{p}) may be made solely of one type, or may be made of two or more types.

In any case, the polymer (F^{q}) contains the repeating units (F^{p}) in an amount of at least 10 mol%, preferably at least 50 mol%, based on the total amount of repeating units. In a case where the polymer (F^{q}) contains such other units (F^{q}), the polymer (F^{q}) contains such other units (F^{q}) in an amount of at most 90 mol%, particularly preferably at most 50 mol%, based on the total amount of repeating units. Such other units (F^{q}) are not particularly limited.

The weight average molecular weight of the polymer (F^{q}) is preferably from 1,000 to 30,000, particularly preferably from 3,000 to 20,000.

The preferred embodiment of the polymer (F^{q}) may be a polymer made solely of repeating units formed by polymerization of the compound (f1^{p}), and may be a polymer having a weight average molecular weight of from 1,000 to 30,000, preferably from 3,000 to 20,000.

The protective film composition (Q) of the present invention contains an alkali soluble polymer (polymer (B^{q})) containing the repeating units (b^{q}) formed by polymerization of the polymerizable compound (b^{q}). It is possible to readily remove the protective film composition (Q) by an alkaline solution since the polymer (B^{q}) is dissolved in the alkaline solution by interaction with an alkali.

The polymer (B^{q}) contains the repeating units (B^{p}) in an amount of preferably at least 10 mol%, particularly preferably at least 50 mol%, based on the total amount of repeating units. The polymer (B^{q}) may be a polymer made solely of the repeating units (b^{p}), or may be a polymer containing the repeating units (b^{p}) and repeating units other than the repeating units (b^{p}) (hereinafter also referred to as "other units (B^{q})"). Further, the repeating units (b^{p}) may be made solely of one type or may be made of two or more types. In a case where the polymer (B^{q}) contains such other units (B^{q}), the polymer (B^{q}) contains such other units (B^{q}) in an amount of at most 90 mol%, particularly preferably at most 50 mol%, based on the total amount of repeating units.

The preferred embodiment of the repeating units (B^{q}) in the polymer (B^{q}) is the same as in the protective film polymer (P).

When the polymer (B^{q}) contains such other units (B^{q}), such other units (B^{q}) are the same as in the polymerizable compound described in such other units (B^{p}) in the protective film polymer (P).

The weight average molecular weight of the polymer (B^{q}) is preferably from 1,000 to 100,000, particularly preferably from 1,000 to 50,000.

The preferred embodiment of the polymer (B^{q}) is a polymer containing from 70 to 100 mol% of repeating units formed by polymerization of the compound (b1^{p}) or the compound (b2^{p}) based on the total amount of repeating units, and further having a weight average molecular weight of from 1,000 to 100,000. A more preferred embodiment may be a polymer made solely of repeating units formed by cyclopolymerization of the compound (b1^{p}), which is a polymer having a weight average molecular weight of from 1,000 to 50,000.

The protective film composition (Q) contains the polymer (F^{q}) and the polymer (B^{q}), and contains from 0.1 to 30 mass% of the polymer (B^{q}) to the polymer (F^{q}). Such a composition more preferably contains from 1 to 10 mass% of the polymer (F^{q}) to the polymer (B^{q}). In such a case, the polymer (F^{q}) and the polymer (B^{q}) are readily compatible with each other, and there is an effect that the film-forming property of the liquid immersion protective film is excellent.

The protective film composition (Q) may also contain a component other than the polymer (F^{q}) and the polymer (B^{q}). Such a component may be an organic solvent, a plasticizer, a stabilizer, a colorant or an anti-halation agent.

The protective film composition (Q) is usually used as applied on a resist film formed on a substrate (such as a silicon wafer) to be formed into a film, and therefore from the viewpoint of its film-forming property, such a composition is preferably a liquid form. The protective film composition (Q) preferably contains an organic solvent.

The present invention provides a protective film composition (hereinafter also referred to as "protective film-forming composition (Q)") containing the protective film composition (Q) and an organic solvent.

The organic solvent in the protective film-forming composition (Q) is not particularly limited so long as it is a solvent having high compatibility with the polymer (F^{q}) and the polymer (B^{q}). As the organic solvent, one type or two or more types may be used.

The organic solvent having high compatibility with the polymer (F^{q}) is preferably a fluorine-containing organic solvent made of a fluorine-containing compound, and from the viewpoint of high compatibility with the polymer (B^{q}), it is particularly preferred to use a fluorine-containing organic solvent made of a fluorine-containing compound having a hydrogen atom bonded to a carbon atom. As the fluorine-containing organic solvent, one type or two or more types may be used.

The organic solvent having high compatibility with the polymer (B^{q}) may be a fluorine-containing organic solvent made of a fluorine-containing compound containing fluorine atoms, or may be an organic solvent made of a compound containing no fluorine atoms.

Further, as a specific example of the organic solvent, the organic solvent described as in the protective film-forming composition (1) may be mentioned, and also as a specific example of the fluorine-containing organic solvent, the fluorine-containing organic solvent described as in the protective film-forming composition (1) may be mentioned.

As the organic solvent in the protective film-forming composition (Q), from the viewpoint of the compatibility of the protective film composition (Q), an organic solvent essentially containing a fluorine-containing organic solvent is preferred, and an organic solvent containing at least 50 mass% and less than 100 mass% of a fluorine-containing organic solvent per total mass of the organic solvent is particularly preferred. Further, as the organic solvent in the present invention, for the purpose of letting the polymer (F^{q}) and the polymer (B^{q}) uniformly dissolve therein, preferred is an organic solvent essentially containing an alcohol organic solvent made of an alcohol containing no fluorine atoms (for example, an alcohol as in the above non-fluorine type organic solvent), and particularly preferred is an organic solvent containing from 0.01 to 10 mass% of an alcohol organic solvent based on the total amount of the organic solvent. Further, the organic solvent is preferably contained in an amount of from 100 mass% to 10,000 mass% based on the total amount of the polymer (F^{q}) and the polymer (B^{q}).

The production process of the protective film-forming composition (Q) may be not particularly limited, and may be a process in which a solution (hereinafter referred to as "resin solution (F^{q})") obtained by dissolving the polymer (F^{q}) in a fluoine-containing organic solvent and a solution (hereinafter referred to as "resin solution (B^{q})") obtained by dissolving the polymer (B^{q}) in an organic solvent are respectively prepared, and then the resin solution (F^{q}) and the resin solution (B^{q}) are mixed with each other. The resin solution (F^{q}) preferably contains from 0.1 to 10 mass% of the polymer (F^{q}). Further, the resin solution (B^{q}) preferably contains from 0.1 to 20 mass% of the polymer (B^{q}).

The protective film-forming composition (Q) is used for a liquid immersion lithography method. The embodiment of the liquid immersion lithography method is the same as in the liquid immersion lithography method in which the protective film-forming composition (P) is used.

In a step of liquid immersion exposure in a liquid immersion lithography method in which the protective film composition (Q) is used, a resist film is insulated from a liquid medium (such as water) by a protective film made of the protective film composition (Q), whereby the liquid medium hardly penetrates therein, and further a component in the resist film is hardly eluted into the liquid medium. Accordingly, in the step of liquid immersion exposure, the resist film hardly swells, and optical characteristics such as the refractive index of the liquid medium hardly change. Further, in the step of liquid immersion exposure, water readily follows a projector lens which relatively moves over the resist protective film, whereby it is possible to stably conduct the step of liquid immersion exposure.

Further, the present invention provides a resist material (hereinafter also referred to as "resist material (W)") for lithography, which comprises a polymer containing the repeating units (F^{w}) formed by polymerization of the polymerizable compound (f^{w}) having a fluorine-containing bicyclic bridged cyclic structure.

The polymerizable compound (f^{w}) is preferably the following compound (f1^{w}) or the following compound (f2^{w}). 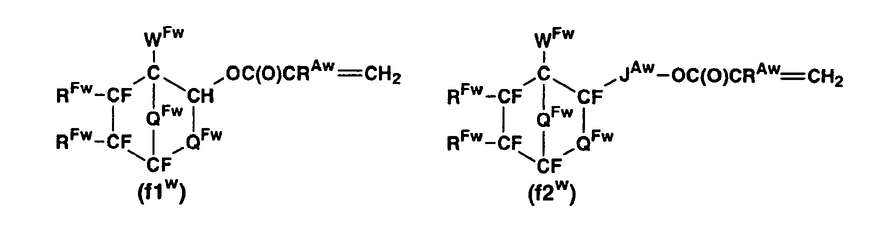 wherein the symbols have the following meanings:
W^{Fw}: A fluorine atom or a trifluoromethyl group.
R^{Fw}: A fluorine atom or a C₁₋₁₆ perfluoroalkyl group, and two R^{Fw}s may be the same or different.
Q^{Fw}: -CF₂- or -C(CF₃)₂-, and two Q^{Fw}s may be the same or different.
R^{Aw}: A hydrogen atom, a fluorine atom, a C₁₋₃ alkyl group or a C₁₋₃ fluoroalkyl group.
J^{Aw}: A C₁₋₁₀ alkylene group which may contain an etheric oxygen atom.

The resist material (W) in the present invention is excellent in the water repellency, especially in the dynamic water repellency. The reason is not clearly understood, but is considered to be such that the resist material (W) contains a fluoropolymer having a bulky structure derived from a fluorine-containing bicyclic bridged cyclic structure of the polymerizable compound (f^{w}). Accordingly, from the resist material (W), it is possible to readily prepare a resist member on which the immersion fluid readily slides and in which the immersion fluid is hardly penetrated.

The polymerizable compound (f^{w}) is a compound having a polymerizable group and a fluorine-containing bicyclic bridged cyclic structure, and is not particularly limited so long as it is a compound having a fluorine atom bonded to a carbon atom constituting the fluorine-containing bicyclic bridged cyclic structure.

The polymerizable group is preferably a group having a polymerizable carbon atom-carbon atom double bond.

The fluorine-containing bicyclic bridged cyclic structure is preferably an aliphatic group, particularly preferably a saturated aliphatic group. Further, -O-, -C(O)O- or -C(O)- may be introduced between the carbon atom-carbon atom in the fluorine-containing bicyclic bridged cyclic structure. Further, to the carbon atom in the fluorine-containing bicyclic bridged cyclic structure, a hydroxyl group or a carboxyl group may be bonded.

The content of fluorine in the polymerizable compound (f^{w}) is preferably at least 30 mass%, particularly preferably at least 50 mass%. The upper limit of the above content of fluorine is preferably at most 76 mass%. The carbon number of the polymerizable compound (f^{w}) is preferably from 8 to 20.

The configuration of an asymmetric center on a main chain of the compound (f1^{w}) or the compound (f2^{w}) may be endo or exo.

R^{Aw} is preferably a hydrogen atom, a fluorine atom, a methyl group or a trifluoromethyl group, particularly preferably a hydrogen atom or a methyl group.

As R^{Fw}, it is preferred that both of them are fluorine atoms, or one is a fluorine atom and the other is a C₁₋₁₆ perfluoroalkyl group, and it is particularly preferred that both of them are fluorine atoms.

J^{Aw} is preferably a methylene group.

A specific example of the polymerizable compound (f^{w}) is the same as in the compounds described in the specific example of the polymerizable compound (f^{m}).

The compound (f1^{w}) is a novel compound. It is possible to produce the compound (f1^{w}) in such a manner that the following compound (f1^{51w}) and R^{fPw}-COF are subjected to an esterification reaction to obtain the following compound (f1^{41w}), then the compound (f1^{41w}) is subjected to a liquid phase fluorination reaction to obtain the following compound (f1^{3w}), then the compound (f1^{3w}) is subjected to a thermal decomposition reaction in the presence of KF to obtain the following compound (f1^{2w}), then the compound (f1^{2w}) is subjected to a reduction reaction to obtain the compound (f1^{1w}), and then the compound (f1^{1w}) and CH₂=CR^{Aw}C(O)Cl are reacted with each other. 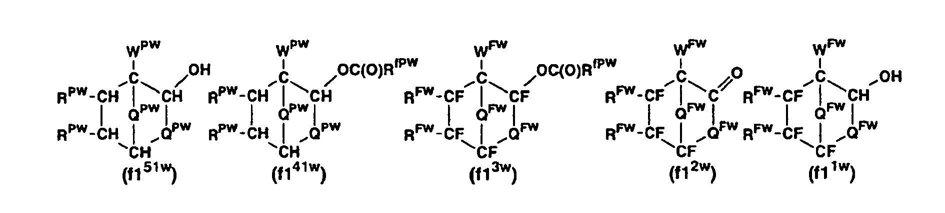 wherein the symbols have the following meanings:
R^{fPw}: A C₁₋₂₀ perfluoroalkyl group which may contain an etheric oxygen atom.
W^{Pw}: A group corresponding to W^{Fw}, which is a hydrogen atom or a methyl group.
R^{Pw}: A group corresponding to R^{Fw}, which is a hydrogen atom or a C₁₋₁₆ alkyl group. Two R^{Pw}s may be the same or different.
Q^{Pw}: A group corresponding to Q^{Fw}, which is -CH₂- or -C(CH₃)₂-. Two Q^{Pw}s may be the same or different.

The compound (f1^{3w}) may be obtained also by a liquid phase fluorination reaction of the following compound (f1^{42w}) obtained in the same way except that the following compound (f1^{52w}) is used instead of the compound (f1^{51w}).

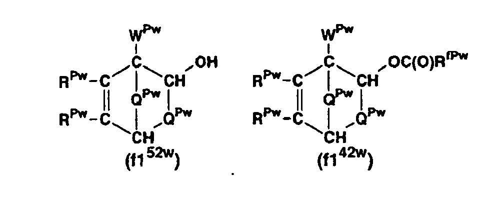

The compound (f2^{w}) is a novel compound. It is possible to produce the compound (f2^{w}) by using the following compound (f2^{2w}) obtained in such a manner that the following compound (f2^{51w}) and R^{fPw}-COF are subjected to an esterification reaction to obtain the following compound (f2^{41w}), then the compound (f2^{41w}) is subjected to a liquid phase fluorination reaction to obtain the following compound (f2^{3w}), and then the compound (f2^{3w}) is subjected to a thermal decomposition reaction in the presence of KF.

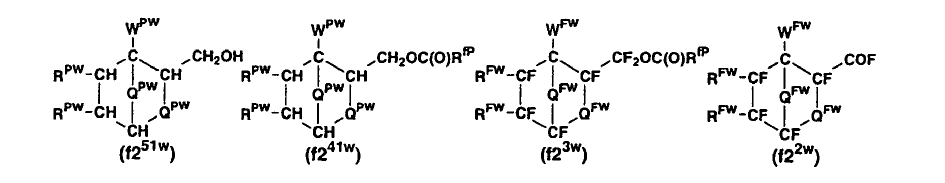

For example, it is possible to produce the following compound (f2^{Mw}) in such a manner that the compound (f2^{2w}) and methanol are reacted to obtain the following compound (f2^{2Mw}), then the compound (f2^{2Mw}) is subjected to a reduction reaction to obtain the following compound (f21^{1Mw}), and then the compound (f21^{1Mw}) and CH₂=CR^{w}C(O)Cl are reacted with each other.

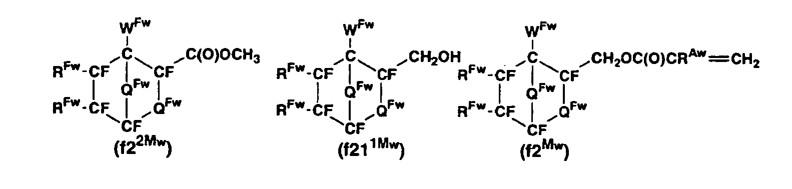

The compound (f2^{3w}) may also be obtained by a liquid phase fluorination reaction of the following compound (f2^{42w}) in the same way except that the following compound (f2^{52w}) is used instead of the compound (f2^{51w}).

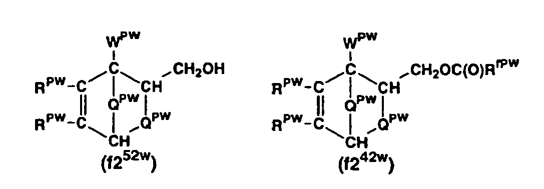

A method for polymerizing the polymerizable compound (f^{w}) may be a method for polymerizing the polymerizable compound (f^{w}) in the presence of a polymerization initiator. The polymerization initiator may be an organic peroxide, an inorganic peroxide or an azo compound. The temperature, pressure and time for the polymerization are not particularly restricted.

The present invention provides a polymer for a resist protective film (hereinafter referred to as "protective film polymer (W)") for immersion lithography, which is an alkali soluble polymer containing the repeating units (F^{w}) and the repeating units (B^{w}) formed by polymerization of the polymerizable compound (b^{w}) having a hydroxyl group, a carboxyl group, a sulfonic acid group, a sulfonyl amide group, an amino group or a phosphoric acid group, wherein the repeating units (F^{w}) are contained in an amount of from 1 to 70 mol% and the repeating units (B^{w}) is contained in an amount of at least 10 mol%, based on the total amount of repeating units.

The protective film polymer (W) of the present invention is particularly excellent in the dynamic water repellency since it contains the repeating units (F^{w}). In an immersion lithography method employing a resist protective film prepared from the protective film polymer (W), the immersion fluid readily follows a projector lens which moves over a resist protective film at a high speed. Further, the protective film polymer (W) is an alkali soluble polymer since it contains the repeating units (B^{w}). It is possible to readily remove the following resist protective film by an alkali solution. Accordingly, by the protective film polymer (W) of the present invention, it is possible to conduct a high-speed immersion lithography method which is capable of transferring a pattern image of a mask with high resolution.

The polymerizable compound (f^{w}) in the protective film polymer (W) is preferably the compound (f1^{w}) or the compound (f2^{w}).

The polymerizable compound (b^{w}) in the protective film polymer (W) is preferably a polymerizable compound having a hydroxyl group or a carboxyl group. The hydroxyl group may be an alcoholic hydroxyl group or a phenolic hydroxyl group.

From the viewpoint of the water repellency and the alkaline affinity of the protective film polymer (W), the polymerizable compound (b^{w}) is more preferably a polymerizable compound having a hydroxyl group or a carboxyl group bonded to a carbon atom adjacent to a carbon atom having a polyfluoroalkyl group bonded thereto, particularly preferably a polymerizable compound having -C(CF₃) (OH)-, -C(CF₃)₂(OH) or -C(O)OH.

The polymerizable compound (b^{w}) is preferably the compound (b1) to the compound (b4), particularly preferably the compound (b1).

The protective film polymer (W) of the present invention may be a polymer made solely of the repeating units (F^{w}) and the repeating units (B^{w}), or may be a polymer further containing other units. Further, the repeating units (F^{w}) in the protective film polymer (W) may be one type or at least two types. Further, the repeating units (B^{w}) in the protective film polymer (W) may be one type or at least two types.

The protective film polymer (W) preferably contains from 1 to 50 mol% of the repeating units (F^{w}) based on the total repeating units. The protective film polymer (W) preferably contains from 50 to 99 mol% of the repeating units (B^{w}) based on the total repeating units.

The weight average molecular weight of the protective film polymer (W) is preferably from 1,000 to 100,000, particularly preferably from 1,000 to 50,000.

A preferred embodiment of the protective film polymer (W) may be a polymer made solely of the repeating units (F^{w}) and the repeating units (B^{w}), which contains from 1 to 50 mol% of the repeating units (F^{w}) and from 50 to 99 mol% of the repeating units (B^{w}), based on the total repeating units.

The repeating units (B^{w}) in the above embodiment are preferably repeating units formed by polymerization of the compound (b1), particularly preferably repeating units formed by polymerization of
CF₂=CFCF₂C(CF₃) (OH) CH₂CH=CH₂,
CF₂=CFCH₂CH(C(CF₃)₂(OH) CH₂CH=CH₂ or
CF₂=CFCH₂CH(C(O) OH) CH₂CH=CH₂.

The weight average.molecular weight of the polymer in the above preferred embodiment is preferably from 1,000 to 30,000.

In an application to an immersion lithography method, the protective film polymer (W) is usually used as applied on the surface of a photosensitive resist film formed on a substrate, whereby it is preferred that such a polymer is prepared to be a liquid composition.

The present invention provides a composition (hereinafter, also referred to as "protective film-forming composition (W)") for a resist protective film for immersion lithography, which contains the protective film polymer (W) and an organic solvent.

The protective film-forming composition (W) preferably contains from 100 mass% to 10,000 mass% of an organic solvent based on the total mass of the protective film polymer (W).

The organic solvent is not particularly limited so long as it is a solvent having high compatibility with the protective film polymer (W). A specific example of the organic solvent may be the same as in the organic solvent described as in the protective film-forming composition (1).

The protective film-forming composition (W) may also contain a component other than the protective film polymer (W) and the organic solvent. As a specific example of such a component, a plasticizer, a stabilizer, a colorant or an anti-halation agent may be mentioned.

The present invention provides a method for forming a resist pattern on a substrate, which comprises sequentially carrying out a step of applying a photosensitive resist material on a substrate to form a resist film on the substrate, a step of applying the protective film-forming composition (W) on the resist film to form a resist protective film on the resist film; a step of immersion lithography, and a step of development.

A specific embodiment of the immersion lithography method is the same as in the immersion lithography method in which the protective film-forming composition (1) is employed.

Further, the present invention provides a resist protective film composition (hereinafter referred to as "protective film composition (V)") for immersion lithography, which comprises the alkali soluble polymer (B^{w}) and the polymer (FB^{w}) containing the repeating units (F^{w}), in which the repeating units (F^{w}) are contained in an amount of at least 10 mol% based on the total amount of repeating units, wherein the polymer (FB^{w}) is contained in an amount of from 0.1 to 30 mass% to the polymer (B^{w}).

The protective film composition (V) of the present invention is particularly excellent in the dynamic water repellency since it contains the polymer (FB^{w}) containing the repeating units (F^{w}). In the immersion lithography method employing a resist protective film prepared from the protective film composition (V), the immersion fluid readily follows a projector lens which moves over the resist protective film at a high speed. Further, the protective film composition (V) is an alkali soluble composition since it contains the polymer (B^{w}). It is possible to readily remove the above resist protect film by alkali solution. Accordingly, by the protective film composition (V), it is possible to stably conduct an immersion lithography method at a high speed, which is capable of transferring a pattern image of a mask with high resolution.

The polymerizable compound (f^{w}) in the protective film composition (V) is preferably the compound (f1^{w}) or the compound (f2^{w}).

The polymer (FB^{w}) in the protective film composition (V) may be a polymer made solely of the repeating units (F^{w}), or may be a polymer containing repeating units other than the repeating units (F^{w}) (hereinafter also referred to as "other units (FB^{w})"). In either case, the polymer (FB^{w}) contains the repeating units (F^{w}) in an amount of at least 10 mol%, preferably at least 20 mol%, based on the total repeating units. In a case where the polymer (FB^{w}) contains such other units (FB^{w}), such other units (FB^{w}) are contained in an amount of preferably at most 90 mol%, particularly preferably at most 50 mol%, based on the total amount of repeating units.

Such other units (FB^{w}) are not particularly limited, but are preferably the repeating units (FB^{w}) formed by polymerization of the polymerizable compound (b^{w}).

A preferred embodiment of the polymerizable compound (b^{w}) in the protective film composition (V) is the same as in the polymerizable compound (b^{w}) in the protective film polymer (W).

The weight average molecular weight of the polymer (FB^{w}) is preferably from 1,000 to 100,000, particularly preferably from 1,000 to 50,000.

As a preferred embodiment of the polymer. (FB^{w}), the following polymer (FB^{wH}) and the following polymer (FB^{wc}) may be mentioned.

Polymer (FB^{wH}): A polymer made solely of the repeating units (F^{w}).

Polymer (FB^{wC}): A polymer containing the repeating units (F^{w}) and such other units (FB^{w}), wherein the repeating units (F^{w}) are contained in an amount of from 10 to 70 mol% and such other units (FB^{w}) are contained in an amount of from 50 to 90 mol%, based on the total amount of repeating units.

Such other units (FB^{w}) in the Polymer (FB^{wC}), are preferably repeating units formed by polymerization of the polymerizable compound having -C(CF₃)(OH)-, -C(CF₃)₂(OH) or -C(O)OH, particularly preferably repeating units formed by polymerization of the compound (b1).

The weight average molecular weight in the above preferred embodiment is preferably from 1,000 to 30,000.

The polymer (B^{w}) is preferably a polymer containing the repeating units (B^{w}) formed by polymerization of the polymerizable compound (b^{w}). A preferred embodiment of the polymerizable compound (b^{w}) in the polymer (B^{w}) is the same as in the polymerizable compound (b^{w}) in the protective film polymer (W).

Further, in such a case, the polymer (B^{w}) may be a polymer made solely of the repeating units (B^{w}) or may be a polymer further containing other units. Further, the repeating units (B^{w}) may be made solely of one type or may be made of at least two types. The polymer (B^{w}) particularly preferably contains at least 50 mol% of the repeating units (B^{w}) based on the total amount of repeating units.

The weight average molecular weight of the polymer (B^{w}) is preferably from 1,000 to 100,000, particularly preferably from 1,000 to 50,000.

A preferred embodiment of the polymer (B^{w}) may be a polymer containing the repeating units (B^{w}), wherein the repeating units (B^{w}) are contained in an amount of from 70 to 100 mol% based on the total amount of repeating units. A particularly preferred embodiment may be a polymer made solely of the repeating units (B^{w}).

The repeating units (B^{w}) of the polymer in the above preferred embodiment is preferably repeating units formed by polymerization of the compound (b1).

The weight average molecular weight of the polymer in the above preferred embodiment is preferably from 1,000 to 50,000.

The protective film composition (V) contains the polymer (FB^{w}) and the polymer (B^{w}), and the polymer (FB^{w}) is contained in an amount of from 0.1 to 30 mass% to the polymer (B^{w}). The polymer (FB^{w}) is more preferably contained in an amount of from 1 to 10 mass% to the polymer (B^{w}). In such a case, the polymer (FB^{w}) and the polymer (B^{w}) are readily compatible with each other, and there is an effect that the film-forming property of the protective film will be excellent.

In an application to an immersion lithography method, the protective film composition (V) is usually used as applied on the surface of a photosensitive resist film formed on the substrate, whereby it is preferred that such a polymer is prepared to be a liquid composition.

The present invention provides a composition (hereinafter, also referred to as "protective film-forming composition (V)") for forming a resist protective film for immersion lithography, comprising the protective film composition (V) and an organic solvent.

The protective film-forming composition (V) preferably contains from 100 mass% to 10,000 mass% of an organic solvent based on the total mass of the protective film composition (V).

The organic solvent is not particularly limited so long as it is a solvent having high compatibility with the protective film composition (V). A specific example of the organic solvent may be the same as in the organic solvent described as in the protective film-forming composition (1).

The present invention provides a method for forming a resist pattern on a substrate, which comprises sequentially carrying out a step of applying a photosensitive resist onto a substrate to form a resist film, a step of applying the protective film-forming composition (V) on the resist film to form a resist protective film on the resist film, a step of an immersion lithography, and a step of development.

A specific embodiment of the immersion lithography method is the same as in the immersion lithography method in which the protective film-forming composition (1) is employed.

### EXAMPLES

Now, the present invention will be described in detail with reference to Examples, but the present invention is by no means restricted to these Examples.

In Examples, a gel permeation chromatography method will be referred to as "GPC method", a weight average molecular weight as "Mw", a number average molecular weight as "Mn", and a glass transition temperature as "Tg".

Further, dichloropentafluoropropane (mixed product of CF₃CF₂CHCl₂ and CF₂ClCF₂CHFCl) will be referred to as "R225", 1,1,2-trichloro-1,2,2-trifluoroethane as "R113", diisopropylperoxydicarbonate as "IPP", tetramethylsilane as "TMS", tetrahydrofuran as "THF", 2-propanol as "IPA", and perfluorobenzoyl peroxide as "PFBPO".

Mw and Mn of a polymer were measured by means of a gel permeation chromatography method (development solvent: THF, internal standard: polystyrene). Further, a composition of each polymer was determined by measurement of ¹⁹F-NMR and ¹H-NMR. Tg of a polymer was measured by means of differential scanning calorimetry.

In order to produce the polymer (F), the compound (f¹), the compound (f²), the compound (f³), the compound (f⁴), the compound (b¹) or the compound (b²) was used.

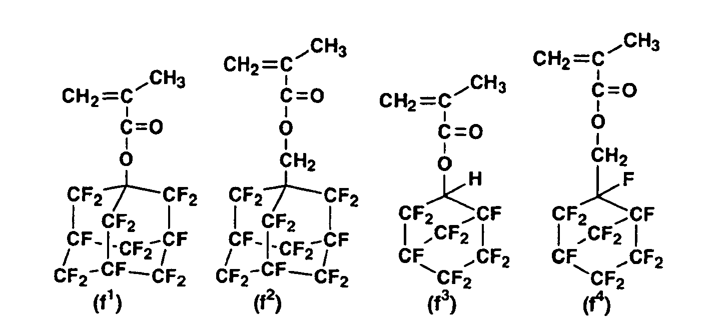

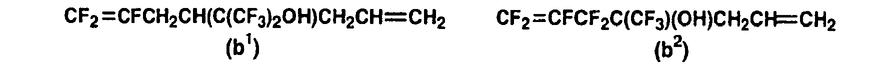

Further, repeating units formed by polymerization of the compound (f¹) will be referred to as "units (F¹)", repeating units formed by polymerization of the compound (f²) as "units (F²)", repeating units formed by polymerization of the compound (f³) as "units (F³)", and repeating units formed by polymerization of the compound (f⁴) as "units (F⁴)".

Further, repeating units represented by the following formula (B¹) formed by polymerization of the compound (b¹) will be referred to as "units (B¹)", and repeating units formed by the following formula (B¹) formed by polymerization of the compound (b²) as "units (B²)".

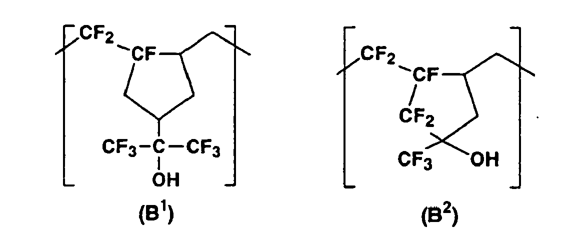

### EXAMPLE 1 (REFERENCE SYNTHETIC EXAMPLE): Production

### Example of Compound (f)

### EXAMPLE 1-1: Production Example of Compound (f²)

To a flask maintained at 0°C, the following compound (pf²) (27.46 g), NaF (3.78) and acetone (100 mL) were added, followed by stirring. Then, water (1.14 g) was dropwise added to the flask, and the interior of the flask was sufficiently stirred. The solution in the flask was purified by sublimation to obtain the following compound (qf²) (22.01 g).

To a mixture of the compound (qf²) (2.03 g) and dimethylsulfoxide (50 mL) in the flask, potassium hydroxide (1.00 g) and an aqueous formalin solution (20 mL) were added, followed by reaction for 6.5 hours at 75°C. After completion of the reaction, a reaction solution was extracted with R225 (40 mL), and then R225 was distilled off to obtain the following compound (rf²) (1.58 g).

The compound (rf²) (6.01 g) obtained in the same way and R225 (103 g) were added to a flask, then triethylamine (1.68 g) and CH₂=C(CH₃)COCl (1.58 g) were gradually added thereto, and then the interior of the flask was stirred at 25°C for 2 hours. A solution in the flask was filtrated, and obtained filtrate was washed twice with water (50 mL). Then, the solution in the flask was dried over magnesium sulfate, followed by concentration to obtain a pale yellow solid material (6.19 g). The solid material was purified with a column chromatography to obtain the compound (f²). 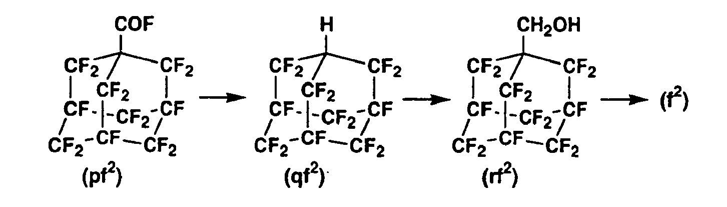 NMR data of the compound (f²) is shown as follows:
¹H-NMR (300.4 MHz, CDCl₃, internal standard; Si(CH₃)₄) δ (ppm): 1.96 (s, 3H), 5.06 (s, 2H), 5.71 (s, 1H), 6.19 (s, 1H).
¹⁹F-NMR (282.7 MHz, CDCl₃, internal standard; CFCl₃) δ (ppm): -113.6 (6F), -121.1 (6F), -219.4 (3F).

### EXAMPLE 1-2: Production Example of Compound (f³)

According to the production route represented by the following formula, the compound (f³) was produced from the following compound (nf³), wherein R^{f1}- represents F(CF₂)₃OCF(CF₃)CF₂OCF(CF₃)-.

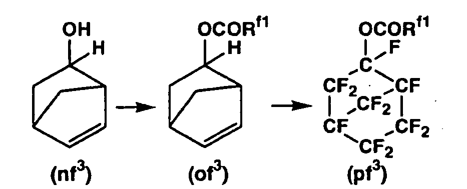

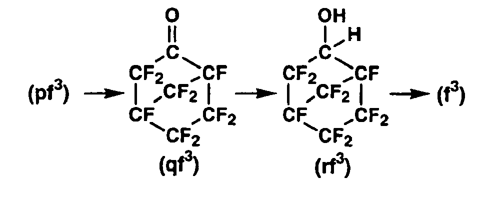

Under nitrogen gas atmosphere, the compound (nf³) (15 g), chloroform (100 g) and NaF (7.02 g) were added to a flask, then R^{F1}-COF (79 g) was dropwise added thereto while the interior of the flask was stirred under cooling with ice, and after completion of the dropwise addition, the interior of the flask was further stirred. An insoluble solid material in the flask was removed by pressure filtration, then an aqueous saturated sodium hydrogen carbonate solution (103 g) was added to the flask, and then an organic layer was separated and concentrated to obtain the compound (of³) (74 g).

R113 (313 g) was added to an autoclave provided with an NaF pellet-packed layer at the gas outlet thereof, and nitrogen gas was blown into the autoclave for an hour while the interior of the autoclave was stirred at 25°C, and then fluorine gas diluted to 20 volume% with nitrogen gas was blown thereto. While the 20 volume% fluorine gas was blown as it was, a solution obtained by dissolving the compound (of³) (67 g) in R113 (299 g) was injected to the autoclave under a pressure of 0.1 MPa. After completion of the injection, the material in the autoclave was concentrated to obtain the compound (pf³).

Under nitrogen gas atmosphere, the compound (pf³) (80 g) and powdery KF (0.7 g) were added to a flask, the interior of the flask was heated for 6 hours, and the material in the flask was purified to obtain the compound (qf³) (38 g).

Under nitrogen gas atmosphere, NaBH₄ (1.1 g) and THF (30 g) were added to a round flask. While the flask was stirred under cooling with ice, an R225 solution (48 g) containing 22 mass% of the compound (qf³) was dropwise added to the flask. After completion of the dropwise addition, the interior of the flask was further stirred, the solution in the flask was neutralized with an aqueous hydrochloric acid solution (150 mL), and obtained solution was washed with water and then purified by distillation to obtain the compound (rf³).

The compound (rf³) (2.2 g), THF (10 g), an aluminum salt (2 mg) of N-nitrosophenylhydroxyamine and triethylamine (1.2 g) were added to a flask. While the flask was stirred under cooling with ice, a solution obtained by dissolving CH₂=C(CH₃)C(O)Cl (1.2 g) in THF (7.3 g) was dropwise added to the flask. After completion of the dropwise addition, the interior of the flask was further stirred, and an aqueous sodium hydrogen carbonate solution was added thereto. The solution in the flask was extracted with R225, and the extract was dried over and concentrated to obtain a concentrated fluid, followed by purification with a silica gel column chromatography to obtain the compound (f³) (2.7 g).
NMR data of the compound (f³) is shown as follows:
¹H-NMR (300.4 MHz, solvent: CDCl₃, standard; TMS) δ (ppm): 6.31 (1H), 5.88 (1H), 5.84 (1H), 2.01 (3H).
¹⁹F-NMR (282.7 MHz, solvent: CDCl₃, standard; CFCl₃) δ (ppm): -104.6 (1F), -120.5 (1F), -122.4 (1F), -124.2 (1F), -124.6 (1F), -126.5 (1F), -132.7 to -132.8 (2F), -214.8 (1F), -223.2 (1F).

### EXAMPLE 1-3: Production Fxample of Compound (f⁴)

According to the production route represented by the following formula, the compound (f⁴) was produced from the following compound (nf⁴), wherein R^{f2}- represents F(CF₂)₃OCF(CF₃)-.

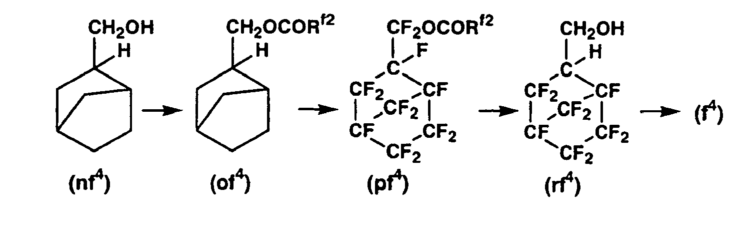

Under nitrogen gas atmosphere, the compound (nf⁴) (26 g) and R225 (100 g) were added to a flask, R^{F2}-COF (91 g) was dropwise added thereto while the interior of the flask was stirred under cooling with ice, and after completion of the dropwise addition, the interior of the flask was further stirred. The material in the flask was concentrated and filtrated to obtain the compound (of⁴) (88 g).

R113 (326 g) was added to an autoclave provided with an NaF pellet-packed layer at a gas outlet thereof, nitrogen gas was blown to the autoclave for one hour while the interior of the autoclave was stirred at 25°C, and then fluorine gas diluted to 20 volume% with nitrogen gas was blown thereto. While the 20% fluorine gas was blown as it was, a solution obtained by dissolving the compound (of⁴) (75 g) in R113 (346 g) was injected to the autoclave under a pressure of 0.1 MPa. After completion of the injection, a material in the autoclave was concentrated to obtain the compound (pf⁴).

To a solution obtained by dissolving the compound (pf⁴) (106 g) in R225 (100 mL), methanol (20 g) was dropwise added under cooling with ice. After completion of the dropwise addition, the solution was stirred at 25°C, and then R225 and F(CF₂)₃OCF(CF₃)COOCH₃ were distilled off from the solution to obtain a reaction product (42 g). To a solution containing the reaction product and THF (100 mL), a hexane solution (20 g) containing 79 mass% of ((CH₃)₂CHCH₂)₂AlH was dropwise added. After completion of the dropwise addition, the solution was stirred, and then neutralized with an aqueous 0.2 mol/L hydrochloric acid solution to obtain a reaction crude liquid. The reaction crude liquid was extracted with R225, then a low-boiling point component in an extract was distilled off, and further the reaction crude liquid was purified by recrystallization in hexane to obtain the compound (rf⁴).

The compound (rf⁴) (16.3 g), *tert*-butyl methyl ether (82 ml), hydroquinone (5mg) and triethylamine (8.1 g) were added to a flask. While the interior of the flask was stirred under cooling with ice, CH₂=C(CH₃)C(O)Cl (8.4 g) was dropwise added to the flask. After completion of the dropwise addition, the interior of the flask was stirred, and then pure water (50 mL) was added to the flask to obtain a double layered liquid. The upper layer of the double layered liquid was separated, and then dried over and concentrated to obtain a concentrated fluid. The concentrated fluid was purified with a silica gel column chromatography to obtain the compound (f4) (14 g).
NMR data of the compound (f⁴) is shown as follows:
¹H-NMR (300.4 MHz, solvent: CDCl₃, standard; TMS) δ (ppm): 6.20 (1H), 5.70 (1H), 4.75 (2H), 1.98 (3H).
¹⁹F-NMR (282.7 MHz, solvent: CDCl₃, standard; CFCl₃) δ (ppm): ¹⁹F-NMR (282.7 MHz, solvent: CDCl₃, standard; CFCl₃) δ (ppm): -118.6 (1F), -120.6 (1F), -123.8 (2F), -124.5 (1F), -124.9 (1F), -128.6 (1F), -131.4(1F), -179.1 (1F), -219.8 (1F), -227.0 (1F).

### EXAMPLE 2: Production Example of Polymer for Resist Protective Film for Immersion Lithography (No. 1)

### EXAMPLE 2-1: Production Example of Polymer (F¹)

To a pressure resistant reactor (internal capacity: 30 mL, made of glass), the compound (f¹) (0.54 g), the compound (b¹) (4.0 g), R225 (19.9 g) and IPA (0.4 g) were charged, and then, IPP (0.76 g) in the form of a 50 mass% R225 solution was added as a polymerization initiator. Then, the interior of the reactor was deaerated under reduced pressure, and the internal temperature of the reactor was maintained at 40°C to carry out a polymerization reaction for 18 hours. Then, the solution in the reactor was dropwise added to hexane to recover the solid content as a reprecipitate, followed by vacuum drying at 100°C for 24 hours to obtain the polymer (F¹) (4.11 g).

The polymer (F¹) was a white powdery amorphous polymer (Tg: 106°C) at 25°C, and was soluble in each of acetone, THF, ethyl acetate, methanol and R225. The polymer (F¹) had Mn of 7,200 and Mw of 13,900. Further, the polymer (F¹) was a polymer containing 7 mol% of the units (F¹) and further containing 93 mol% of the units (B¹).

### EXAMPLE 2-2: Production Example of Polymer (F²)

To a pressure resistant reactor (internal capacity: 100 mL, made of glass), the compound (b¹) (6.0 g), R225 (27.7 g) and IPA (0.56 g) were charged, and then, IPP (1.15 g) in the form of a 50 mass% R225 solution was added as a polymerization initiator.

Then, while the internal temperature of the reactor was maintained at 40°C, a mixture of the compound (f¹) (1.02 g), R225 (3.08 g) and IPA (0.06 g) was dropwise added to the reactor over a period of 6 hours to carry out a polymerization reaction. After completion of the dropwise addition of the mixed fluid, the polymerization reaction was carried out for 12 hours. Thereafter the fluid in the reactor was dropwise added to hexane to recover a solid content as a reprecipitate, followed by vacuum drying at 90°C for 24 hours to obtain the polymer (F²) (5.77 g).

The polymer (F²) was a white powdery amorphous polymer at 25°C, and was soluble in each of acetone, THF, ethyl acetate, methanol and R225. The polymer (F²) had Mn of 5,600 and Mw of 11,600. Further, the polymer (F²) was a polymer containing 9 mol% of the units (F¹) and further containing 91 mol% of the units (B¹).

### EXAMPLE 2-3: Production Example of Polymer (F³)

To a pressure resistant reactor (internal capacity: 30 mL, made of glass), the compound (f¹) (0.35 g), the compound (b¹) (4.0 g), R225 (14.3 g) and IPA (2.80 g) were charged, and then, IPP (0.65 g) in the form of a 50 mass% R225 solution was added as a polymerization initiator. Then, the interior of the reactor was deaerated under reduced pressure, and the internal temperature of the reactor was maintained at 40°C for 18 hours to carry out a polymerization reaction. Then, the solution in the reactor was concentrated, diluted with R225, and then dropwise added to hexane to recover a solid content as a reprecipitate, followed by vacuum drying at 90°C for 24 hours to obtain the polymer (F³) (2.72 g).

The polymer (F³) was a white powdery amorphous polymer (Tg: 92°C) at 25°C, and was soluble in each of acetone, THF, ethyl acetate, methanol and R225. The polymer (F³) had Mn of 4,300 and Mw of 6,400. Further, the polymer (F³) was a polymer containing 5.6 mol% of the units (F¹) and 94.4 mol% of the units (B¹).

### EXAMPLE 2-4: Production Example of Polymer (F⁴)

To a pressure resistant reactor (internal capacity: 100 mL, made of glass), the compound (b¹) (6.0 g), R225 (25.5 g) and IPA (4.14 g) were charged, and IPP (1.38 g) in the form of a 50 mass% R225 solution was added as a polymerization initiator.

Then, while the internal temperature of the reactor was maintained at 40°C, a mixture of the compound (f¹) (1.02 g), R225 (1.34 g) and IPA (0.22 g) was dropwise added to the reactor over a period of 6 hours to carry out a polymerization reaction. After completion of the dropwise addition of the mixed fluid, the polymerization reaction was carried out for 12 hours as it was. Thereafter the fluid in the reactor was concentrated, diluted with R225, and then dropwise added to recover a solid content as a reprecipitate, followed by vacuum drying at 90°C for 24 hours to obtain the polymer (F⁴) (4.25 g).

The polymer (F⁴) was a white powdery amorphous polymer (Tg: 86°C) at 25°C, and was soluble in each of acetone, THF, ethyl acetate, methanol and R225. The polymer (F⁴) had Mn of 2,700 and Mw of 4,900. Further, the polymer (F⁴) was a polymer containing 9 mol% of the units (F¹) and further containing 91 mol% of the units (B¹)_{.}

### EXAMPLE 2-5: Production Example of Polymer (F⁵)

To a pressure resistant reactor (internal capacity: 30 mL, made of glass), the compound (f¹) (0.7 g), the compound (b¹) (4.0 g), ethyl acetate (12.3 g) and 1,4-dioxane (6.19 g) were charged, and then, IPP (0.71 g) in the form of a 50 mass% R225 solution was added as a polymerization initiator. Then, the interior of the reactor was deaerated under reduced pressure, the internal temperature of the reactor was maintained at 40°C to carry out a polymerization reaction for 18 hours. Thereafter, the fluid in the reactor was concentrated and then diluted with R225, and then dropwise added to hexane to recover a solid content as a reprecipitate, followed by vacuum drying at 90°C for 24 hours to obtain the polymer (F⁵) (3.51 g).

The polymer (F⁵) was a white powdery amorphous polymer at 25°C, and was soluble in each of acetone, THF, ethyl acetate, methanol and R225. The polymer (F⁵) had Mn of 3,200 and Mw of 6,700. Further, the polymer (F⁵) was a polymer containing 10 mol% of the units (F¹) and further containing 90 mol% of the units (B¹).

### EXAMPLE 2-6: Production Example of Polymer (F⁶)

To a pressure resistant reactor (internal capacity: 30 mL, made of glass), the compound (f¹) (0.25 g), the compound (b¹) (3.0 g), ethyl acetate (8.4 g) and 1,4-dioxane (4.49 g) were charged, and then, PFBPO (0.49 g) was added thereto as a polymerization initiator. Then, the interior of the reactor was deaerated under reduced pressure, and the internal temperature of the reactor was maintained at 40°C to carry out a polymerization reaction for 18 hours. Thereafter, the fluid in the reactor was concentrated and then diluted with R225, and then dropwise added to hexane to recover a solid content as a reprecipitate, followed by vacuum drying at 90°C for 24 hours to obtain the polymer (F⁶) (1.98 g).

The polymer (F⁶) was a white powdery amorphous polymer at 25°C, and was soluble in each of acetone, THF, ethyl acetate, methanol and R225. The polymer (F⁶) had Mn of 3,200 and Mw of 6,500. Further, the polymer (F⁶) was a polymer containing 7 mol% of the units (F¹) and further containing 93 mol% of the units (B¹).

### EXAMPLE 3: Evaluation Example of Polymer for Resist Protective Film for Immersion Lithography (No. 1)

### EXAMPLE 3-1: Evaluation Example of Water Repellency

A silicon substrate was spin-coated with a resin solution obtained by dissolving 5 parts of the polymer (F¹) in 95 parts of 2-methyl-1-propanol, followed by heat treatment at 130°C for 90 seconds to obtain a silicon substrate on which a thin film (thickness: 130 nm) made of the polymer (F¹) was formed. The water repellency (the static contact angle, the sliding angle and the receding angle; units thereof are respectively (° ), the same applies hereinafter) of the thin film was measured. Further, the sliding angle measured by means of a sliding method will be referred to as "sliding angle", and a receding contact angle measured by the sliding method will be referred to as "receding angle" (the same applies hereinafter).

Further, the measurements were carried out in the same way except that the polymers (F²) to (F⁶) were used instead of the polymer (F¹). The results are summarized in Table 1.

**TABLE 1**

| Material for forming a thin film | Static contact angle | Sliding angle | Receding angle |
|---|---|---|---|
| Polymer (F¹) | 94 | 13 | 82 |
| Polymer (F²) | 81 | 21 | 67 |
| Polymer (F³) | 89 | 17 | 72 |
| Polymer (F⁴) | 81 | 18 | 68 |
| Polymer (F⁵) | 90 | 18 | 76 |
| Polymer (F⁶) | 82 | 21 | 70 |

As is clear from the above results, the polymers (F¹) to (F⁶) are excellent in the water repellency since they have high contact angles, and they are particularly excellent in the dynamic water repellency since they have low sliding angles and high receding angles. Accordingly, in the case of using the polymer for a resist protective film for immersion lithography of the present invention, a liquid medium (such as water) readily follows a projector lens which moves over a resist protective film, whereby it is possible to achieve an efficient immersion lithography method.

### EXAMPLE 3-2: Evaluation Example of Dissolution Rate

A quartz crystal was spin-coated with the resin solution obtained in Example 3-1, followed by heat treatment at 130°C for 90 seconds to form a thin film (thickness: 130 nm) made of the polymer (F¹) on the quartz crystal. Then, the quartz crystal was immersed in an aqueous solution containing 2.38 mass% of tetramethylammonium hydroxide (hereinafter referred to as "TMAH"), and the film reduction speed (unit: nm/s) of the thin film in the aqueous TMAH solution was measured as a dissolution rate (unit: nm/s) of the thin film, by means of a quartz crystal microbalance (QCM) method. Further, the dissolution rate of the thin film of each of the polymers (F²) to (F⁶) was measured in the same way. The results are summarized in Table 2.

**TABLE 2**

| Material for forming a thin film | Dissolution rate |
|---|---|
| Polymer (F¹) | 133 |
| Polymer (F²) | 42 |
| Polymer (F³) | 368 |
| Polymer (F⁴) | 92 |
| Polymer (F⁵) | 210 |
| Polymer (F⁶) | 191 |

As is clear from the above results, the polymers (F¹) to (F⁶) are readily soluble in an aqueous alkaline solution, whereby it is possible to readily remove the polymers by such an aqueous alkaline solution. Accordingly, in the case of using the polymer for a resist protective film for immersion lithography of the present invention, it is possible to remove the resist protective film and an irradiated portion of a photosensitive resist all at once after the step of immersion lithography, whereby it is possible to achieve an efficient immersion lithography method.

### EXAMPLE 3-3: Formation Example of Resist Pattern

5 Parts of the polymer (F¹) is dissolved in 95 parts of 2-methyl-1-propanol to prepare a resin solution. A silicon substrate which is surface-treated with an organic anti-reflection film (BARC) is spin-coated with a resist composition (tradename: PAR715 manufactured by Sumitomo Chemical Co., Ltd.), followed by heat treatment to obtain a silicon wafer having a resist film (thickness: 150 nm) formed thereon. Then, the surface of the resist film on the silicon wafer is spin-coated with the above resin solution, followed by heat treatment to obtain a silicon wafer on which a resist protective film (thickness: 30 nm) made of the polymer (F¹) is formed.

By using a two-beam interference exposure apparatus (light source wavelength: 193 nm), the above silicon wafer is subjected to a step of liquid immersion exposure (liquid immersion medium: ultrapure water) at 90 nmL/S. After the step of liquid immersion exposure, a step (heating step) of heating the silicon wafer at 130°C for 60 seconds and a step (developing step) of immersing the silicon wafer in an aqueous solution containing 2.38 mass% of TMAH at 23°C for 60 seconds are sequentially carried out.

It is possible to confirm by an SEM image that a good resist pattern is formed on the surface of a silicon substrate after the developing step. Further, in a case where the liquid immersion exposure test was carried out in the same way except that each of the polymers (F²) to (F⁶) is used instead of the polymer (F¹), it is possible to confirm by an SEM image that a good resist pattern is formed on the surface of a silicon substrate.

### EXAMPLE 4: Production Example of Polymer for Resist Protective Film for Immersion Lithography (No. 2)

### EXAMPLE 4-1: Production Example of Polymer (F⁷)

To a reactor (made of glass, internal capacity: 30 mL), the compound (b¹) (2.0 g), the compound (f³) (0.19 g), R225 (8.3 g) and IPA (0.29 g) were charged. Then, an R225 solution containing 50 mass% of IPP (0.33 g) as a polymerization initiator was charged thereto. The atmosphere in the reactor was replaced with nitrogen gas by deaeration, and then a polymerization reaction was carried out at 40°C for 18 hours while the interior of the reactor was stirred.

After the polymerization, the solution in the reactor was dropwise added to hexane, and obtained agglomerate was dried by vacuum drying at 100°C for 24 hours to obtain a white powdery polymer (F⁷) (2.03 g) at 25°C.

The polymer (F⁷) had Mn of 6,700, Mw of 12,800, and Tg of 100°C. The polymer (F⁷) was confirmed to be a polymer containing 94 mol% of the units (B¹) and 6 mol% of the units (F³). Further, the polymer (F⁷) was soluble in each of acetone, THF, ethyl acetate, methanol and R225.

### EXAMPLE 4-2: Production Example of Polymer (F⁸)

To a reactor (made of glass, internal capacity: 30 mL), the compound (b¹) (1.0 g), the compound (f³) (0.13 g), R225 (4.3 g) and IPA (0.11 g) were charged. Then, an R225 solution containing 50 mass% of IPP (0.17 g) as a polymerization initiator was charged thereto. The atmosphere in the reactor was replaced with nitrogen gas by deaeration, and then a polymerization reaction was carried out at 40°C for 18 hours while the interior of the reactor was stirred.

After the polymerization, the solution in the reactor was dropwise added to hexane, and obtained agglomerate was dried by vacuum drying at 100°C for 24 hours to obtain a white powdery polymer (F⁸) (0.9 g) at 25°C.

The polymer (F⁸) had Mn of 7,900, Mw of 14,200 and Tg of 106°C. The polymer (F⁸) was confirmed to be a polymer containing 92 mol% of the units (B¹) and 8 mol% of the units (F³). Further, the polymer (F⁸) was soluble in each of THF, ethyl acetate, methanol and R225.

### EXAMPLE 4-3: Production Example of Polymer (F⁹)

To a reactor (made of glass, internal capacity: 30 mL), the compound (b¹) (2.0 g), the compound (f⁴) (0.26 g), R225 (9.9 g) and IPA (0.21 g) were charged. Then, an R225 solution containing 50 mass% of IPP (0.38 g) as a polymerization initiator was charged thereto. The atmosphere in the reactor was replaced with nitrogen gas by deaeration, and then a polymerization reaction was carried out at 40°C for 18 hours while the interior of the reactor was stirred.

After the polymerization, the solution in the reactor was dropwise added to hexane, and obtained agglomerate was dried by vacuum drying at 100°C for 24 hours to obtain a white powdery polymer (F⁹) (1.99 g) at 25°C.

The polymer (F⁹) had Mn of 7,200, Mw of 13,000 and Tg of 105°C. The polymer (F⁹) was confirmed to be a polymer containing 94 mol% of the units (B¹) and 6 mol% of the units (F⁴). Further, the polymer (F⁹) was soluble in each of THF, ethyl acetate, methanol and R225.

### EXAMPLE 5: Evaluation Example of Polymer for Resist Protective Film for Immersion Lithography (No.1)

### EXAMPLE 5-1: Evaluation Example of Water Repellency

A solution obtained by dissolving the polymer (F⁷) in 2-methyl-1-propanol was filtrated through a filter to obtain a resin solution containing 5 mass% of the polymer (F⁷).

A silicon substrate having an anti-reflection film formed on its surface was spin-coated with the above resin solution, followed by heat treatment to form a resin thin film of the polymer (F⁷) on the silicon substrate. Thereafter, the static contact angle, the sliding angle and the receding angle of the resin thin film to water were respectively measured.

Measurement was carried out in the same way except that the polymer (F⁸) or (F⁹) was used instead of the polymer (F⁷). The results are summarized in Table 3.

**TABLE 3**

| Material for forming a resin thin film | Contact angle | Sliding angle | Receding angle |
|---|---|---|---|
| Polymer (F⁷) | 90 | 19 | 74 |
| Polymer (F⁸) | 94 | 17 | 85 |
| Polymer (F⁹) | 99 | 20 | 84 |

### EXAMPLE 5-2: Evaluation Example of Dissolution Rate

A quartz crystal was spin-coated with the resin solution in Example 5-1, followed by heat treatment to form a resin thin film of the polymer (F⁷) on the quartz crystal. The film reduction speed of the resin thin film, measured by means of a microbalance method, was 450 nm/s when the quartz crystal was immersed in an aqueous tetramethylammonium hydroxide solution.

### EXAMPLE 5-3: Example of Forming Resist Pattern

A silicon substrate having an anti-reflection film formed on its surface is spin-coated with a photosensitive resist composition (tradename: PAR715, manufactured by Sumitomo Chemical Co., Ltd.), followed by heat treatment to obtain a silicon substrate on which a resist film formed from the above photosensitive resist composition is formed. Further, the surface of the above resist film is spin-coated with the resin solution in Example 5-1, followed by heat treatment to form a resist protective film layer made of the polymer (F⁷) on the surface of the above resist film.

Then, by using a two-beam interference exposure apparatus in which ArF laser (wavelength: 193 nm) is used as a light source, the silicon substrate is subjected to an immersion exposure test (immersion fluid: ultrapure water, developer: an aqueous tetramethylammonium hydroxide solution) at 90 nmL/S. As a result, it is possible to confirm by an SEM image that a good pattern is formed on a resist film on the silicon substrate.

As is clear from the above results, by using the polymer for a resist protective film for immersion lithography of the present invention, it is possible to form a resist protective film excellent in the alkali solubility and the water repellency, particularly excellent in the dynamic water repellency. Accordingly, in an immersion lithography method, it is possible to let water readily follow a projector lens which moves over a resist protective film at a high speed.

### EXAMPLE 6: Production Example of Resist Protective Film

### Composition for Immersion Lithography (No. 1)

A polymer having Mw of 11,000, which is made of the units (B¹) was used as the polymer (B¹), a polymer having Mw of 6,000, which is made of the units (B¹), was used as the polymer (B²), and a polymer having Mw of 5,000, which is made of the units (B²), was used as the polymer (B³) ((the same applies hereinafter).

### EXAMPLE 6-1: Production Example of Polymer (F¹⁰)

To a pressure resistant reactor (internal capacity: 30 mL, made of glass), the compound (f¹) (2.5 g) and CF₃(CF₂)₅H (5.25 g) were charged. Then, an R225 solution containing 50 mass% of IPP (1.17 g) was added thereto as a polymerization initiator. After the interior of the reactor was freeze-deaerated, a polymerization reaction was carried out at 40°C for 18 hours. After the polymerization reaction, the solution in the reactor was dropwise added to methanol to obtain a solid material agglomerated, and the solid material was vacuum-dried at 90°C for 24 hours to obtain the polymer (F¹⁰) (2.05 g). The polymer (F¹⁰) was a white powdery amorphous polymer at 25°C. The polymer (F¹⁰) had Mn of 2,900 and Mw of 6,300.

### EXAMPLE 6-2: Production Example of Polymer (F¹¹)

To a pressure resistant reactor (internal capacity: 30 mL, made of glass), the compound (f²) (0.8 g) and CF₃(CF₂)₅H (1.06 g) were charged. Then, an R225 solution containing 50 mass% of IPP (0.28 g) was added thereto as a polymerization initiator. After the interior of the reactor was freeze-deaerated, a polymerization reaction was carried out at 40°C for 18 hours. After the polymerization reaction, the solution in the reactor was dropwise added to methanol to obtain a solid material agglomerated, and the solid material was vacuum-dried at 90°C for 24 hours to obtain the polymer (F¹¹) (0.62 g). The polymer (F¹¹) was a white powdery amorphous polymer at 25°C. The polymer (F¹¹) had Mn of 7,000 and Mw of 20,000.

### EXAMPLE 6-3: Production Example of Composition (1)

The polymer (F¹⁰) was dissolved in methaxylene hexafluoride to obtain the solution (F¹⁰) containing 0.36 mass% of the polymer (F¹⁰). The polymer (B¹) was dissolved in a solution containing 99.5 mass% of methaxylene hexafluoride and 0.5 mass% of 2-methyl-1-propanol to obtain the solution (B¹) containing 5.8 mass% of the polymer (B¹). 1.149 g of the solution (F¹⁰) and 1.827 g of the solution (B¹) were mixed with each other to obtain a transparent and homogeneous solution. Such a solution was filtrated through a filter (PTFE-made) with a pore diameter of 0.2 µm to obtain the composition (1) containing 3.9 mass% of the polymer (F¹⁰) based on the total amount of the polymer (F¹⁰) and the polymer (B¹).

### EXAMPLE 6-4: Production Example of Composition (2)

The composition (2) containing 3.5 mass% of the polymer (F¹⁰) based on the total amount of the polymer (B¹) was obtained in the same manner as in Example 6-3 except that the polymer (B¹) was dissolved in a solution containing 98.9 mass% of methaxylene hexafluoride and 1.1 mass% of 2-methyl-1-propanol.

### EXAMPLE 6-5: Production Example of Composition (3)

The polymer (F¹¹) was dissolved in methaxylene hexafluoride to obtain the solution (F¹¹) containing 0.35 mass% of the polymer (F¹¹). The polymer (B²) was dissolved in a solution containing 99.3 mass% of methaxylene hexafluoride and 0.7 mass% of 2-methyl-1-propanol to obtain the solution (B²) containing 5.5 mass% of the polymer (B²). 1.146 g of the solution (F¹¹) and 1.824 g of the solution (B²) were mixed with each other to obtain a transparent and homogeneous solution. Such a solution was filtrated through a filter (PTFE-made) with a pore diameter of 0.2 µm to obtain the composition (3) containing 4.0 mass% of the polymer (F¹¹) based on the total amount of the polymer (F¹¹) and the polymer (B²).

### EXAMPLE 6-6: Production Example of Composition (4)

The composition (4) containing 8.0 mass% of the polymer (F¹¹) based on the total amount of the polymer (B²) was obtained in the same manner as in Example 6-5.

### EXAMPLE 6-7: Production Example of Composition (5)

The composition (5) containing 4.0 mass% of the polymer (F¹¹) based on the total amount of the polymer (B¹) was obtained in the same manner as in Example 6-5 except that the polymer (B¹) was used instead of the polymer (B²).

### EXAMPLE 6-8: Production Example of Composition (6)

The composition (6) containing 8.0 mass% of the polymer (F¹¹) based on the total amount of the polymer (B¹) was obtained in the same manner as in Example 6-5 except that the polymer (B¹) was used instead of the polymer (B²).

### EXAMPLE 6-9: Production Example of Composition (7)

The polymer (F¹⁰) was dissolved in methaxylene hexafluoride to obtain the solution (F¹²) containing 0.69 mass% of the polymer (F¹⁰). The polymer (B³) was dissolved in a solution containing 37.5 mass% of methaxylene hexafluoride and 62.5 mass% of decafluoro-1-hexanol to obtain the solution (B³) containing 4.2 mass% of the polymer (B³). 0.577 g of the solution (F¹²) and 2.394 g of the solution (B³) were mixed with each other to obtain a transparent and homogeneous solution. Such a solution was filtrated through a filter (PTFE-made) with a pore diameter of 0.2 µm to obtain the composition (7) containing 4.0 mass% of the polymer (F¹⁰) based on the total amount of the polymer (F¹⁰) and the polymer (B³).

### EXAMPLE 6-10: Production Example of Composition (C)

In a solution containing 99.2 mass% of methaxylene hexafluoride and 0.8 mass% of 2-methyl-1-propanol, a polymer (hereinafter referred to as "polymer (C)") having Mw of 100,000 obtained by homopolymerization of CH₂=C(CH₃)CH₂CH₂CF₂)₆F was dissolved to obtain the solution (C) containing 0.35 mass% of the polymer (C). 1.152 g of the solution (C) and 1.817 g of the solution (B¹) were mixed with each other to obtain a transparent and homogeneous solution. Such a solution was filtrated through a filter (PTFE-made) with a pore diameter of 0.2 µm to obtain the composition (C) containing 4.0 mass% of the polymer (C) based on the total amount of the polymer (C) and the polymer (B¹).

### EXAMPLE 7: Evaluation Example of Resist Protective Film Composition for Immersion Lithography (No. 1)

### EXAMPLE 7-1: Evaluation Example of Water Repellency

A silicon substrate having an anti-reflection film (tradename: AR26, manufactured by ROHM AHD HAAS Electronic Materials K.K.) formed on its surface was spin-coated with the composition (1). Then, the silicon substrate was subjected to heat treatment at 100°C for 90 seconds, and further subjected to heat treatment at 130°C for 120 seconds to form a resin thin film (thickness: 150 nm) containing the polymer (F¹⁰) and the polymer (B¹) on the silicon substrate. Thereafter, the static contact angle, the sliding angle and the receding angle of the resin thin film to water were respectively measured.

Measurements were carried out in the same way except that the compositions (2) to (7) and the composition (C) were respectively used instead of the composition (1). Further, the static contact angle, the sliding angle and the receding angle of a resin thin film made solely of the polymer (B1) or the polymer (B3) were also measured. The results are summarized in Table 4.

**TABLE 4**

| Material for forming a resin thin film | Static contact angle | Sliding angle | Receding angle |
|---|---|---|---|
| Composition (1) | 109 | 11 | 98 |
| Composition (2) | 108 | 11 | 100 |
| Composition (3) | 96 | 16 | 86 |
| Composition (4) | 100 | 14 | 91 |
| Composition (5) | 98 | 16 | 83 |
| Composition (6) | 100 | 13 | 90 |
| Composition (7) | 97 | 18 | 83 |
| Composition (C) | 100 | 29 | 75 |
| Polymer (B¹) | 70 | 19 | 61 |
| Polymer (B³) | 64 | 25 | 50 |

As is clear from the above results, it is found that the resin thin film formed from a composition containing the polymer (F) and the polymer (B) is excellent in the water repellency as compared with a resin thin film formed from the polymer (B) alone. Further, the above resin thin film has a small sliding angle and a large receding angle as compared with a resin thin film containing the polymer (B) and the polymer (C) having a linear fluoroalkyl group, whereby it is found that such a resin thin film is excellent in the dynamic water repellency. Accordingly, by using the resist protective film composition for immersion lithography of the present invention, a liquid medium (such as water) readily follows a projector lens which moves over a resist protective film, whereby it is possible to stably conduct an immersion lithography method.

### EXAMPLE 7-2: Evaluation Example of Dissolution Rate

In the same manner as in Example 7-1, the composition (1) was applied on a silicon substrate, and a resin thin film (thickness: 158 nm) containing the polymer (F¹⁰) and the polymer (B¹) was formed on the silicon substrate. The silicon substrate was immersed in an aqueous solution containing 2.38 mass% of tetramethylammonium hydroxide, and the speed for dissolution (hereinafter referred to as "Dissolution Rate") of the resin thin film in the aqueous solution was measured by means of a quartz crystal microbalance method.

A resin thin film was formed on the silicon substrate in the same way except that the composition (3) or (4) was used instead of the composition (1), whereby the dissolution rate (nm/s) of a resin thin film to the above aqueous solution was measured. The results are summarized in Table 5.

**TABLE 5**

| Material for forming a resin thin film | Dissolution rate |
|---|---|
| Composition (1) | 735 |
| Composition (3) | 878 |
| Composition (4) | 878 |

As is clear from the above results, it is possible to readily remove a resin thin film formed from a composition containing the polymer (F) and the polymer (B), by an aqueous alkali solution. Accordingly, in the case of using the resist protective film composition for immersion lithography of the present invention, it is possible to readily remove the resist protective film and an irradiated portion of a photosensitive resist all at once after the step of liquid immersion exposure, whereby it is possible to efficiently conduct an immersion lithography method.

### EXAMPLE 7-3: Formation Example of Resist Pattern

A silicon substrate having an anti-reflection film formed on its surface is spin-coated with a photosensitive resist composition (tradename: PAR715, manufactured by Sumitomo Chemical Co., Ltd.), followed by heat treatment to obtain a silicon substrate on which a resist film formed from the above photosensitive resist composition is formed. Further, the surface of the above resist film is spin-coated with the composition (1), followed by heat treatment to form a resist protective film layer made of the polymer (F¹⁰) and the polymer (B¹), on the surface of the above resist film.

Then, by using a two-beam interference exposure apparatus in which ArF laser (wavelength: 193 nm) is used as a light source, the silicon substrate is subjected to an immersion exposure test (immersion fluid: ultrapure water, developer: aqueous tetramethylammonium hydroxide solution) at 90 nmL/S. As a result, it is possible to confirm by an SEM image that a good pattern is formed on the resist film on the silicon substrate.

### EXAMPLE 8: Production Example of Resist Protective Film Composition for Immersion Lithography (No. 2)

### EXAMPLE 8-1: Production Example of Composition (8)

The polymer (F¹²) (Mw 12,000) obtained by homopolymerization of the compound (f³) was dissolved in 1,3-bis(trifluoromethyl)benzene to prepare a resin solution (hereinafter referred to as "solution (11)") containing 0.36 mass% of the polymer (F¹²).

The polymer (B¹) was dissolved in a solvent made of 1,3-bis(trifluoromethyl)benzene (95.1 mass%) and 2-methyl-1-propanol (4.9 mass%) to prepare a resin solution (hereinafter referred to as "solution (21)") containing 5.4 mass% of the polymer (B¹).

The solution (11) (1.117 g) and the solution (21) (1.855 g) were mixed with each other to obtain the composition (8) containing 4 mass% of the polymer (F¹²) based on the total amount of the polymer (B¹).

### EXAMPLE 8-2: Production Example of Composition (9)

The polymer (F¹²) was dissolved in 1,3-bis(trifluoromethyl)benzene to prepare a resin solution (hereinafter referred to as "solution (12)") containing 0.18 mass% of the polymer (B¹).

The polymer (B¹) was dissolved in a solvent made of 1,3-bis(trifluoromethyl)benzene (96.6 mass%) and 3.4 mass% of 2-methyl-1-propanol (3.4 mass%) to prepare a resin solution (hereinafter referred to as "solution (22)") containing 3.9 mass% of the polymer (B¹).

The solution (12) (1.093 g) and the solution (22) (2.580 g) were mixed with each other to obtain the composition (9) containing 2 mass% of the polymer (F¹²) based on the total mass of the polymer (B¹).

### EXAMPLE 9: Evaluation Example of Resist Protective Film Composition for Immersion Lithography (No. 2)

### EXAMPLE 9-1: Evaluation Example of Water Repellency

A silicon substrate having an anti-reflection film formed on the surface was spin-coated with the composition (8), followed by heat treatment (100°C, 60 seconds) to form a resin thin film containing the polymer (B¹) and the polymer (F¹²) on the silicon substrate. Thereafter, the static contact angle, the sliding angle and the receding angle of the resin thin film to water were respectively measured.

Measurement was carried out in the same way except that the composition (9) was used instead of the composition (8). The results are summarized in Table 6.

**TABLE 6**

| Material for forming a resin thin film | Static contact angle | Sliding angle | Receding angle |
|---|---|---|---|
| Composition (8) | 103 | 15 | 93 |
| Composition (9) | 97 | 18 | 84 |

### EXAMPLE 9-2: Evaluation Example of Dissolution Rate

A quartz crystal was spin-coated with the composition (8), followed by heat treatment to form a resin thin film containing the polymer (B¹) and the polymer (F¹²) on the quartz crystal. The film reduction speed of the resin thin film measured by means of a microbalance method, was at least 200 nm/s when the quartz crystal was immersed in an aqueous tetramethylammonium hydroxide solution.

### EXAMPLE 9-3: Formation Example of Resist Pattern

A silicon substrate having an anti-reflection film formed on its surface is spin-coated with a photosensitive resist composition (tradename: PAR715 manufactured by Sumitomo Chemical Co., Ltd.), followed by heat treatment to obtain a silicon substrate on which a resist film formed from the above photoresist composition is formed. Further, the surface of the above resist film is spin-coated with the composition (8), followed by heat treatment to form a resist protective film layer made of the polymer (B¹) and the polymer (F¹²) on the surface of the above resist film.

By using a two-beam interference exposure apparatus in which ArF laser (wavelength: 193 nm) is used as a light source, the silicon substrate is subjected to an immersion exposure test (immersion fluid: ultrapure water, developer: an aqueous tetramethylammonium hydroxide solution) at 90 nmL/S. As a result, it is confirmed by an SEM image that a good pattern is formed on the resist film on the silicon substrate.

As is clear from the above results, it is found that by using the resist protective film composition for immersion lithography of the present invention, it is possible to form a resist protective film excellent in the alkali solubility and the water repellency, especially in the dynamic water repellency. Accordingly, in an immersion lithography method, it is possible to let water readily follow a projector lens which moves over a resist protective film at a high speed.

### EXAMPLE 10: Production Example of Resist Protective Film Composition for Immersion Lithography (No. 3)

### EXAMPLE 10-1: Production Example of Composition (10)

The compound (f³) and the compound (b¹) were copolymerized to obtain the polymer (F¹³) having Mw of 14,000 and containing 8 mol% of the units (F³) and 92 mol% of the units (B¹), based on the total amount of repeating units. The polymer (F¹³) was dissolved in 4-methyl-2-pentanol to obtain a solution containing 6.17 mass% of the polymer (F¹³). Such a solution (0.972 g) and a solution (1.428 g) containing 4.2 mass% of the polymer (B¹) were mixed with each other to produce the composition (10) containing 100 mass% of the polymer (F¹³) based on the total mass of the polymer (B¹). The composition (10) was a transparent and homogeneous solution.

### EXAMPLE 10-2: Production Example of Composition (11)

The compound (f³) and the compound (b¹) were copolymerized to obtain the polymer (F¹⁴) having Mw of 14,000 and containing 10 mol% of the units (F³) and 90 mol% of the units (B¹), based on the total amount of repeating units. The polymer (F¹⁴) was dissolved in 4-methyl-2-pentanol to obtain a solution containing 3.8 mass% of the polymer (F¹⁴). Such a solution (1.129 g) and a solution (1.728 g) containing 5.8 mass% of the polymer (B¹) were mixed with each other to produce the composition (11) containing 43 mass% of the polymer (F¹⁴) based on the total mass of the polymer (B¹). The composition (11) was a transparent and homogeneous solution.

### EXAMPLE 11: Evaluation Example of Resist Protective Film Composition for Immersion Lithography (No. 3)

### EXAMPLE 11-1: Evaluation Example of Water Repellency

A silicon substrate having an anti-reflection film formed on its surface was spin-coated with the composition (10), followed by heat treatment (100°C, 60 seconds) to form a resin thin film containing the polymer (B¹) and the polymer (F¹³) on the silicon substrate. Thereafter, the static contact angle, the sliding angle and the receding angle of the resin thin film to water were respectively measured.

Measurement was carried out in the same way except that the composition (11) was used instead of the composition (10). The results are summarized in Table 7.

**TABLE 7**

| Material for forming a resin thin film | Static angle | Sliding angle | Receding angle |
|---|---|---|---|
| Composition (10) | 91 | 20 | 74 |
| Composition (11) | 93 | 20 | 79 |

### EXAMPLE 11-2: Evaluation Example of Dissolution Rate

In the same manner as in Example 7-1, a silicon substrate was coated with the composition (10) to form a resin thin film containing the polymer (F¹³) and the polymer (B¹) on the silicon substrate. The silicon substrate was immersed in an aqueous solution containing 2.38 mass% of tetramethylammonium hydroxide, and the speed (unit: nm/s) (hereinafter referred to as "dissolution rate") for dissolution of the resin thin film in the aqueous solution was measured by means of a quartz crystal microbalance method. Further, the dissolution rate was measured in the same way except that the composition (11) was used instead of the composition (10). The results are summarized in Table 8.

**TABLE 8**

| Material for forming a resin thin film | Dissolution rate |
|---|---|
| Composition (10) | 280 |
| Composition (11) | 330 |

### EXAMPLE 11-3: Formation Example of Resist Pattern

A silicon substrate having an anti-reflection film formed on its surface is spin-coated with a photosensitive resist composition (tradename: PAR715, manufactured by Sumitomo Chemical Co., Ltd.), followed by heat treatment to obtain a silicon substrate on which a resist film formed from the above photosensitive resist composition is formed. Further, the surface of the above resist film is spin-coated with the composition (10), followed by heat treatment to form a resist protective film layer made of the polymer (B¹) and the polymer (F¹³) on the surface of the above resist film.

Then, by using a two-beam interference exposure apparatus in which ArF laser (wavelength: 193 nm) is used as a light source, the silicon substrate is subjected to an immersion exposure test (immersion fluid: ultrapure water, developer: an aqueous tetramethylammonium hydroxide solution) at 90 nmL/S. As a result, it is possible to confirm by an SEM image that a good pattern is formed on the resist film on the silicon substrate.

As is clear from the above results, it is found that by using the resist protective film composition for immersion lithography of the present invention, it is possible to form a resist protective film excellent in the alkali solubility and the water repellency, especiallly in the dynamic water repellency.
Accordingly, in an immersion lithography method, it is possible to let water follow a projector lens which moves over a resist protective film at a high speed.

### INDUSTRIAL APPLICABILITY

According to the present invention, it is possible to provide a material for a resist protective film for immersion lithography, which is particularly excellent in the resist protective film characteristics (such as suppression of swelling of a photosensitive resist by infiltration of water, or suppression of elution of a photosensitive resist component into an immersion fluid) and in the dynamic water repellency, and which is hardly be penetrated by water and facilitates sliding of water. By using the material for a resist protective film for immersion lithography of the present invention, it is possible to stably conduct a high-speed immersion lithography method capable of transferring a pattern image of a mask with high resolution.

The entire disclosures of Japanese Patent Application No. 2006-116735 filed on April 20, 2006, Japanese Patent Application No. 2006-144121 filed on May 24, 2006 and Japanese Patent Application No. 2006-207392 filed on July 31, 2006 including specifications, claims and summaries are incorporated herein by reference in their entireties.

## Claims

1. A material for an alkali soluble resist protective film for immersion lithography, which comprises a polymer (F) containing repeating units (F^{U}) formed by polymerization of a polymerizable compound (f^{m}) having a fluorine-containing bridged cyclic structure.

2. The material for a resist protective film for immersion lithography according to Claim 1, wherein the polymerizable compound (f^{m}) is a compound (f) selected from the group consisting of compounds represented by the following formulae (f1), (f2), (f3) and (f4): 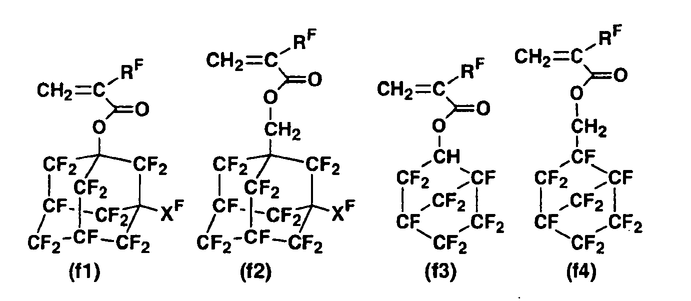 wherein the symbols have the following meanings:
R^{F}: A hydrogen atom, a fluorine atom, a C₁₋₃ alkyl group or a C₁₋₃ fluoroalkyl group,
X^{F}: A fluorine atom, a hydroxyl group or a hydroxymethyl group,
wherein a fluorine atom in the compound (f) may be substituted by a C₁₋₆ perfluoroalkyl group or a C₁₋₆ perfluoroalkoxy group.

3. A polymer for an alkali soluble resist protective film for immersion lithography, which is a polymer (FB) containing repeating units (F^{U}) formed by polymerization of a polymerizable compound (f^{m}) having a fluorine-containing bridged cyclic structure and repeating units (B^{U}) formed by polymerization of a polymerizable compound (b^{m}) having a hydroxyl group, a carboxyl group, a sulfonic acid group, a sulfonylamide group, an amino group or a phosphoric acid group.

4. The polymer for a resist protective film for immersion lithography according to Claim 3, wherein the polymerizable compound (f^{m}) is a compound (f) selected from the group consisting of compounds represented by the following formulae (f1), (f2), (f3) and (f4): 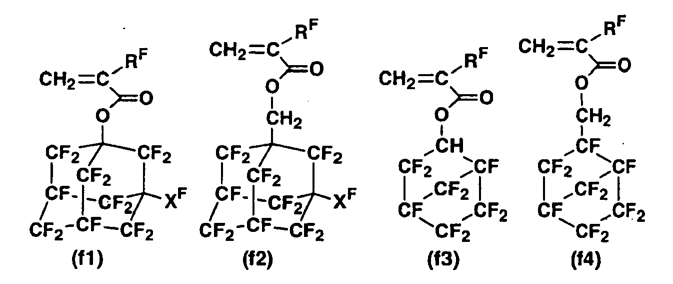 wherein the symbols have the following meanings:
R^{F}: A hydrogen atom, a fluorine atom, a C₁₋₃ alkyl group or a C₁₋₃ fluoroalkyl group,
X^{F}: A fluorine atom, a hydroxyl group or a hydroxymethyl group,
wherein a fluorine atom in the compound (f) may be substituted by a C₁₋₆ perfluoroalkyl group or a C₁₋₆ perfluoroalkoxy group.

5. The polymer for a resist protective film for immersion lithography according to Claim 3 or 4, wherein the polymerizable compound (b^{m}) is a polymerizable compound having a group represented by the formula -C(CF₃) (OH)-, -C(CF₃)₂(OH) or -C(O)OH.

6. The polymer for a resist protective film for immersion lithography according to any one of Claims 3 to 5, wherein the polymerizable compound (b^{m}) is a compound (b) selected from the group consisting of compounds represented by the following formulae (b1), (b2), (b3) and (b4):
CF₂=CF-Q^{B1}-CH=CH₂ (b1)
CH₂=CR^{B2}C(O)O-Q^{B2}(-C(CF₃)₂OH)_{b} (b2)
CH₂=CH-Q^{B3}(-C(CF₃)₂OH)_{b} (b3) 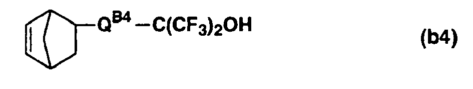
wherein the symbols have the following meanings:
Q^{B1}: A group represented by the formula -CF₂C(CF₃) (OH)(CH₂)ₘ-, a group represented by the formula -CH₂CH ((CH₂)ₙC (CF₃)₂(OH)) (CH₂)ₘ- or a group represented by the formula -CH₂CH(C(O)OH) (CH₂)ₘ-,
m and n: Each independently 0, 1 or 2,
R^{B2}: A hydrogen atom, a fluorine atom, a C₁₋₃ alkyl group or a C₁₋₃ fluoroalkyl group,
Q^{B2} and Q^{B3} : Each independently a C₁₋₂₀ (b+1) valent hydrocarbon group,
b: 1 or 2,
Q^{B4} : a single bond or a C₁₋₁₀ bivalent hydrocarbon group,
wherein a fluorine atom may be bonded to a carbon atom in Q^{B2}, Q^{B3} or Q^{B4}_{.}

7. The polymer for a resist protective film for immersion lithography according to any one of Claims 3 to 6, wherein the polymer (FB) is a polymer containing from 1 to 70 mol% of repeating units (F^{U}) and at least 10 mol% of repeating units (B^{U}) based on the total amount of repeating units.

8. The polymer for a resist protective film for immersion lithography according to any one of Claims 3 to 7, wherein the polymer (FB) is a polymer containing from 3 to 15 mol% of repeating units (F^{U} and from 85 to 97 mol% of repeating units (B^{U}) based on the total amount of repeating units.

9. A composition for forming a resist protective film for immersion lithography, comprising the polymer for a resist protective film for immersion lithography as defined in any one of Claims 3 to 8 and an organic solvent.

10. A method for forming a resist pattern on a substrate, which is a method for forming a resist pattern by immersion lithography, which comprises sequentially carrying out a step of applying a photosensitive resist material on a substrate to form a photosensitive resist film on the substrate, a step of applying the composition for forming a resist protective film for immersion lithography as defined in Claim 9 on the photosensitive resist film to form a resist protective film layer on the photosensitive resist film, a step of immersion lithography, and a step of development.

11. An alkali soluble resist protective film composition for immersion lithography, which comprises a polymer (F) containing repeating units (F^{U} formed by polymerization of a polymerizable compound (f^{m}) having a fluorine-containing bridged cyclic structure and a polymer (B) containing repeating units (B^{U} formed by polymerization of a polymerizable compound (b^{m}) having a hydroxyl group, a carboxyl group, a sulfonic acid group, a sulfonylamide group, an amino group or a phosphoric acid group.

12. The resist protective film composition for immersion lithography according to Claim 11, wherein the polymerizable compound (f^{m}) is a compound (f) selected from the group consisting of compounds represented by the following formulae (f1), (f2), (f3) and (f4): 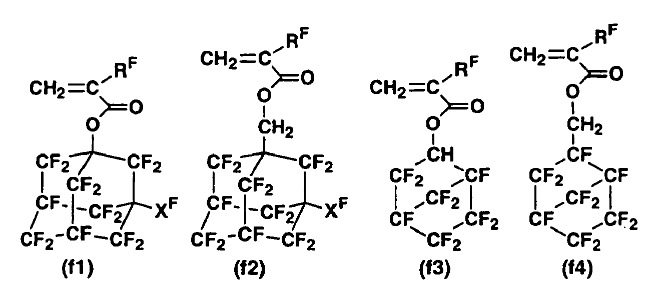 wherein the symbols have the following meanings:
R^{F}: A hydrogen atom, a fluorine atom, a C₁₋₃ alkyl group or a C₁₋₃ fluoroalkyl group,
X^{F}: A fluorine atom, a hydroxyl group or a hydroxymethyl group,
wherein a fluorine atom in the compound (f) may be substituted by a C₁₋₆ perfluoroalkyl group or a C₁₋₆ perfluoroalkoxy group.

13. The resist protective film composition for immersion lithography according to Claim 11 or 12, wherein the polymerizable compound (b^{m}) is a polymerizable compound having a group represented by the formula -C(CF₃)(OH)-, -C(CF₃)₂(OH) or -C(O)OH.

14. The resist protective film composition for immersion lithography according to any one of Claims 11 to 13,
wherein the polymerizable compound (b^{m}) is a compound (b) selected from the group consisting of compounds represented by the following formulae (b1), (b2), (b3) and (b4):
**CF₂=CF-Q^{B1}-CH=CH₂** (b1)
**CH₂=CR^{B2}-C(O)O-Q^{B2}(-C(CF₃)₂OH)_{b}** (b2)
**CH₂=CH-Q^{B3}(-C(CF₃)₂OH)_{b}** (b3) 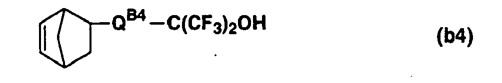
wherein the symbols in the formulae have the following meanings:
Q^{B1}_{:} A group represented by the formula -CF₂C(CF₃) (OH) (CH₂)ₘ-, a group represented by the formula -CH₂CH((CH₂)ₙC(CF₃)₂(OH)) (CH₂)ₘ- or a group represented by the formula -CH₂CH(C(O)OH) (CH₂)ₘ-,
m and n: Each independently 0, 1 or 2,
R^{B2} : A hydrogen atom, a fluorine atom, a C₁₋₃ alkyl group or a C₁₋₃ fluoroalkyl group,
Q^{B2} and Q^{B3}: Each independently a C₁₋₂₀ (b+1) valent hydrocarbon group,
b: 1 or 2,
Q^{B4} : a single bond or a C₁₋₁₀ bivalent hydrocarbon group,
wherein a carbon atom in Q^{B2}, Q^{B3} or Q^{B4} may be bonded to a fluorine atom.

15. The resist protective film composition for immersion lithography according to any one of Claims 11 to 14,
wherein the polymer (F) is a polymer consisting solely of repeating units (F^{U}) formed by polymerizing a polymerizable compound (f^{m}) having a fluorine-containing bridged cyclic structure.

16. The resist protective film composition for immersion lithography according to any one of Claims 11 to 14,
wherein the polymer (F) is a polymer containing repeating units (F^{U}) formed by polymerizing a polymerizable compound (f^{m}) having a fluorine-containing bridged cyclic structure and repeating units (B^{U}) formed by polymerizing a polymerizable compound (b^{m}) having a hydroxyl group, a carboxyl group, a sulfonic acid group, a sulfonylamide group, an amino group or a phosphoric acid group, and the polymer (F) is a polymer containing from 1 to 25 mol% of repeating units (F^{U}) and from 75 to 99 mol% of repeating units (B^{U}) based on the total amount of repeating units.

17. The resist protective film composition for immersion lithography according to any one of Claims 11 to 16,
wherein the polymer (F) is contained in an amount of from 0.1 to 30 mass% based on the polymer (B).

18. The resist protective film composition for immersion lithography according to any one of Claims 11 to 16,
wherein the polymer (F) is contained in an amount of more than 30 mass% and at most 200 mass% based on the polymer (B).

19. A composition for forming a resist protective film for immersion lithography, comprising the resist protective film composition for immersion lithography as defined in any one of Claims 11 to 18 and an organic solvent.

20. A method of forming a resist pattern on a substrate, which is a method of forming a resist pattern by immersion lithography, which comprises sequentially carrying out a step of applying a photosensitive resist material on a substrate to form a photosensitive resist film on a substrate, a step of applying the composition for forming a resist protective film for immersion lithography as defined in Claim 19 on the photosensitive resist film to form a resist protective film layer on the photosensitive resist film, and a step of an immersion lithography, and a step of development.
